# EUROPEAN PATENT APPLICATION

(11) **EP 1 422 705 A1**
(43) Date of publication of application: **26.05.2004**
(21) Application number: 02802062.6
(22) Date of filing: 24.10.2002
(51) Int. Cl.: G11B 7/26, G11B 11/105, C23C 14/34

(54) **METHOD OF FORMING FILM ON OPTICAL DISK**

(30) Priority: 25.10.2001 JP 2001328335
(71) Applicant: MATSUSHITA ELECTRIC INDUSTRIAL CO., LTD., Kadoma-shi, Osaka 571-8501 (JP)
(72) Inventor: MURAKAMI, Motoyoshi, Harakata-shi, Osaka 573-0081 (JP); BIRUKAWA, Masahiro, Hirakata-shi, Osaka 573-0077 (JP)
(74) Representative: Grünecker, Kinkeldey, Stockmair & Schwanhäusser Anwaltssozietät
(86) International application number: PCT/JP2002/011038
(87) International publication number: WO 2003/036633

(57) **Abstract**

A film deposition method for an optical disk of the present invention comprises a step (a) of carrying an optical disk substrate into a vacuum chamber, a step (b) of placing the optical disk substrate opposed to a target containing a film forming material, the target being provided in the vacuum chamber, and a step (c) of forming a predetermined film on the optical disk substrate according to a sputtering method using the target, the substrate being fixed, rotated on its axis, or revolved. When the target has a radius of a and the optical disk substrate has a radius of D, a > 2 x D is satisfied. With this configuration, it is possible to form uniform films of the optical disk in response to a higher density.

## Description

### Technical Field

The present invention relates to, for example, a deposition method of a thin film on an optical disk by using a sputtering apparatus of generating plasma in a vacuum and performing sputtering.

### Background Art

A film deposition method using a sputtering method is a technique of generating plasma of sputtering gas by introducing sputtering gas in a vacuum and applying high voltage to a target, and performing sputtering on the target to deposit a thin film. This method has been widely used for manufacturing optical recording mediums, semiconductor devices, liquid crystal displays, and so on because of a high film deposition speed and a thin film of good quality.

Further, with a magnetron sputtering method of arranging a permanent magnet or an electromagnet near a target, a density of plasma canbe increased in sputtering gas, thereby increasing a film deposition speed.

Additionally, in the present specification, a term "an optical recording medium" means (1) an optical disk as a finished product having various layers laminated on an optical disk substrate, (2) a recording film formed on an optical disk, (3) a film material used for the recording film, and so on.

Such a sputtering method is broadly categorized into a RF sputtering method using a high-frequency power supply and a DC sputtering method using a direct-current power supply according to kinds of applied voltages. As a sputtering method on a conductive material, the DC sputtering method has received attention because an inexpensive power supply can be used, a film deposition velocity is high, and a temperature increase is small on a substrate.

Moreover, in the DC sputtering, a reactive sputtering method is also performed in which reactive gas is introduced together with sputtering gas into a vacuum film deposition chamber to form a film.

For a deposition method of thin films constituting an optical recording medium, a sputtering apparatus has been mainly used in which an optical disk substrate is fixed so as to be statically opposed to the front of a target or the optical disk is opposed to the target while being rotated on its axis.

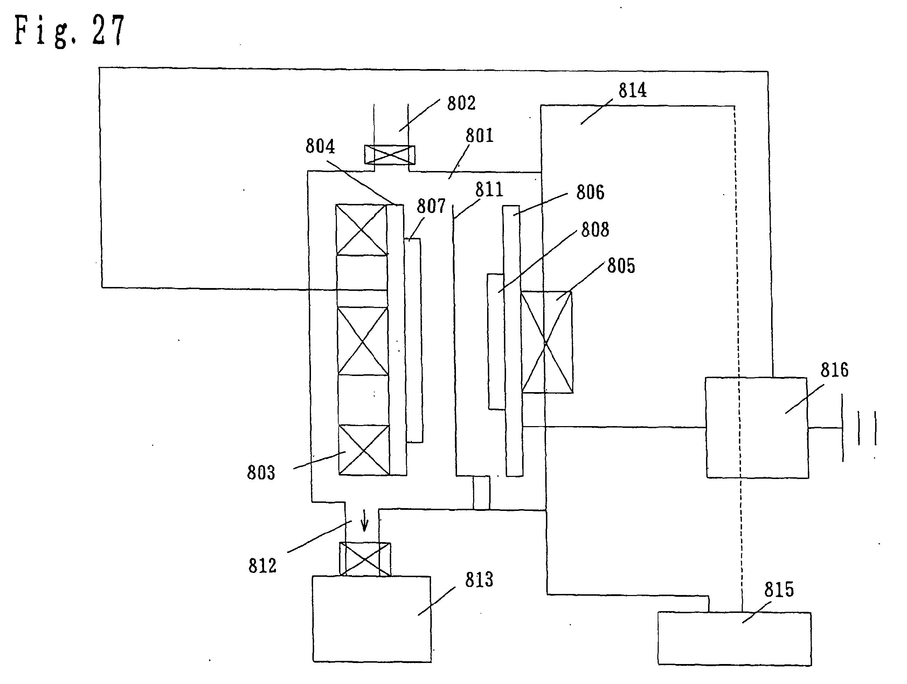

Figure 27 shows an example of a conventional deposition apparatus of a thin film of a optical recording medium (e.g., refer to Japanese Patent Laid-Open No. 2000-353343 as a prior art document).

In Figure 27, a vacuum film deposition chamber 801 comprises a sputtering gas introducing port 802 and a vacuum evacuation port 812 for a vacuum pump 813.

Further, in the vacuum film deposition chamber 801, a sputtering cathode 804 and a substrate holder 806 opposed to the sputtering cathode 804 are placed. The substrate holder 806 is supported by a carrying mechanism 805 on the back and is configured to be transferred to another vacuum film deposition chamber or to the air outside the vacuum film deposition chamber.

A target 807 for film deposition of an optical recording medium is placed on the sputtering cathode 804, and magnets 803 are placed on the back of the target 807 so as to generate a magnetic field on a surface of the target 807. Moreover, an optical disk substrate 808 for film deposition of the optical recording medium is placed on the substrate holder 806 opposed to the target.

Further, the sputtering cathode 804 is connected to a direct-current power supply 816 outside the vacuum film deposition chamber 801 and is configured to perform magnetron sputtering in response to a supply of direct-current power.

Furthermore, a shutter 811 is placed between the substrate holder 806 and the target 807 placed on the sputtering cathode 804. When a recording film of the optical recording medium is not deposited on the optical disk substrate 808, shielding is performed between the target 807 and the optical disk substrate 808, and only when film deposition of the optical recording medium is performed, the shutter 811 is moved to enable film deposition.

In the operations of the sputtering apparatus configured thus, sputtering gas such as Argon gas is introduced into the vacuum film deposition chamber 801 via the sputtering gas introducing port 802, evacuation is performed through the vacuum evacuation port 812, and an amount of introduced gas and an evacuating speed are controlled, so that a pressure in the vacuum film deposition chamber 801 is maintained at an arbitrary value between 0.1 Pa and 1 Pa.

In this way, after the inside of the vacuum film deposition chamber 801 is maintained at a predetermined pressure, direct-current power is supplied from the direct-current power supply 816 to the target 807 placed on the sputtering cathode 804, so that DC discharge is generated. In this state, the shutter 811 is moved. As a result, the shutter 811 is separated from the position of shielding the optical disk substrate 808 and the target 807. Then, an optical recording medium thin film of a target material is deposited on the optical disk substrate.

In this process, the optical recording medium thin film is deposited on a part on the plastic substrate 808 of an insulator other than a mask placed and held on the substrate holder 806.

After the process is completed and discharge caused by sputtering is stopped or low discharged power is maintained by closing the shutter 811, the substrate holder 806 is separated by the carrying mechanism 805 from the position opposed to the target, and is carried to another vacuum film deposition chamber via a carrying vacuum chamber 814 connected to the vacuum film deposition chamber 801.

However, in the conventional sputtering apparatus configured thus, since substrates are carried one by one or plurality at a time in a short period of time and films are deposited thereon, no high-density recording film is formed. Namely, there has been a problem in that when a high-density recording film is formed, a sufficient degree of vacuum is necessary, however, if such a conventional system is used, it is not possible to take enough time for vacuum evacuation and thus it is not possible to form a high-density recording film.

Meanwhile, a configuration has been known which comprises a degassing chamber connected to a loading/unloading chamber in order to obtain enough time for vacuum evacuation. However, there has been a problem in such a configuration. That is, a loading mechanism and an unloading mechanism become complicated to prevent the outside air from oxidizing films, resulting in longer carrying time. Hence, it is not possible to produce an optical disk substrate in a short tact time (First Problem).

Further, in order to obtain a higher density of an optical recording medium, a technique of increasing a density is necessary that adopts a magnetically induced super-resolution technique using multilayer recording films. In order to achieve a higher density, it is significant to prevent interfacial oxidation between the multilayer recording films from changing magnetic properties and to ensure uniform performance of the recording films in the disk. In the conventional apparatus, it is not possible to obtain uniform recording films required for a higher density (Second Problem).

### Disclosure of the Invention

In consideration of the second problem of the above described conventional sputtering apparatus, the present invention has as its object the provision of a film deposition method for an optical disk whereby recording films can be more uniform than the conventional art.

A first invention of the present invention is a film deposition method for an optical disk, comprising:
a step (a) of carrying an optical disk substrate (ex. reference numeral 508) into a vacuum chamber (ex. reference numeral 51),
a step (b) of placing the optical disk substrate (ex. reference numeral 508) opposed to a target (ex. reference numeral 507) containing a film forming material, the target being provided in the vacuum chamber, and
a step (c) of forming a predetermined film on the optical disk substrate by a sputtering method using the target (ex. reference numeral 507), the optical disk substrate being fixed, rotated on an axis, or revolved,
wherein when the target has a radius of a and the optical disk substrate has a radius of D, a > 2 x D is satisfied.

A second invention of the present invention is the film deposition method for the optical disk according to the first invention of the present invention, wherein when a distance between the target (ex. reference numeral 507) and the optical disk substrate (ex. reference numeral 508) is h, a < D + h is satisfied.

A third invention of the preset invention is the film deposition method for the optical disk according to the first or the second invention of the present invention, wherein when a distance between the target and the optical disk substrate is h, h > 30 mm is satisfied.

A fourth invention of the present invention is the film deposition method for the optical disk according to the first invention of the present invention, wherein in the step (c) , the predetermined film is laminated as a fine layered structure in order to form a recording layer (ex. reference numeral 407) of the optical disk.

With this configuration, even in the case of a manufacturing method using a sputtering apparatus whose structure is opposed statically or rotatively, recording films can be increased in density by using recording films of a multilayer structure, and it is possible to achieve a method of manufacturing a recording film of an optical recording medium with high quality and evenness.

A fifth invention of the present invention is the film deposition method for the optical disk according to the fourth invention of the present invention, wherein each layer laminated as the fine layered structure has a thickness equal to or less than a width of a magnetic domain wall or in an order of unit atom.

A sixth invention of the present invention is the film deposition method for the optical disk according to the fourth invention of the present invention, wherein in the step (c) , a film structure of the recording film is formed into the fine layered structure by alternately repeating conduction and non-conduction to the target by using a direct-current power supply.

A seventh invention of the present invention is the film deposition method for the optical disk according to the fourth invention of the present invention, wherein in the step (c), the film is formed while the optical disk substrate is revolved or rotated on its axis, and a film forming area on the optical disk substrate is entirely or partially shielded in synchronization with a rotation period of the revolution or the rotation by using a shielding member (ex. reference numeral 611) placed between the optical disk substrate and the target.

An eighth invention of the present invention is the film deposition method for the optical disk according to the seventh invention of the present invention, wherein the shielding member is a shielding plate made of a metal, and direct-current negative voltage is applied to a cathode electrode connecting the target.

With this configuration, even in the case of a manufacturing method using a sputtering apparatus whose structure is opposed statically or rotatively, it is possible to achieve a method of manufacturing a recording film whereby a recording film capable of recording a fine magnetic domain for high-density recording can be formed by using recording films of a multilayer structure.

A ninth invention of the present invention is the film deposition method for the optical disk according to the eighth invention of the present invention, wherein the shielding plate shields 50 % or more of the film forming area on the optical disk substrate.

A tenth invention of the present invention is the film deposition method for the optical disk according to the seventh invention of the present invention, wherein the revolving or rotating optical disk substrate is 100 rpm or more in number of revolution.

An eleventh invention of the present invention is the film deposition method for the optical disk according to the fourth invention of the present invention, wherein a plurality of vacuum chambers are provided, a step (d) of carrying the optical disk between the vacuum chambers is provided, and
a magnetic layer laminated in the fine layered structure is formed in the step (c) while the optical disk is passed through some or all of the vacuum chambers.

A twelfth invention of the present invention is the film deposition method for the optical disk according to the eleventh invention of the present invention, wherein targets placed in each of the plurality of vacuum chambers have same material or composition.

A thirteenth invention of the present invention is the film deposition method for the optical disk according to the eleventh invention of the present invention, wherein target placed in each of the plurality of vacuum chambers is a target material obtained by combining different compositions.

With this configuration, for example, even when tact time is accelerated during deposition of recording films, it is possible to stably form recording films of a multilayer structure of the optical recording medium, achieve an optical recording medium with high quality, and achieve recording films with uniform characteristics in the intra-surface direction. Further, also when time for degassing from an optical disk substrate is shortened to speed up the manufacturing of recording films, it is possible to reduce an amount of oxygen entering the recording film and grow films by stable sputtering without increasing film deposition time and carrying time, thereby achieving an even optical recording medium and a manufacturing method thereof.

### Brief Description of the Drawings

Figure 1 is a sectional view showing the disk configuration of an optical recording medium according to the present invention;
Figure 2(a) is a disk sectional view of the optical recording medium that illustrates the reproducing principle of a DWDD system;
Figure 2(b) is a characteristic diagram showing a temperature distribution in the medium relative to a position of the optical recording medium during a reproducing operation;
Figure 2(c) is a characteristic diagram showing an energy density of a magnetic domain wall in a reproduction layer;
Figure 2(d) is a characteristic diagram showing a force of moving the magnetic domain wall in the reproduction layer;
Figure 3 is a structural block diagram showing a sputtering apparatus according to Embodiments 1 and 2 of the present invention;
Figure 4 is a structural sectional view showing a vacuum film deposition chamber according to the embodiment of the present invention;
Figure 5 is a characteristic diagram showing dependence of carrier level on a mark length of an optical disk when the movement of a magnetic domain wall in a magneto-optical recording medium of the present invention is used to perform high-density recording and reproduction;
Figure 6 is a structural block diagram showing a sputtering apparatus according to Embodiments 3 and 5 of the present invention;
Figure 7 is a structural sectional view showing a vacuum film deposition chamber for etching that comprises an ion gun of the sputtering apparatus according to the embodiment of the present invention;
Figure 8(a) is a structural sectional view showing a groovy shape of an optical disk substrate according to the embodiment of the present invention;
Figure 8(b) is a structural sectional view showing a groovy shape of a conventional optical disk substrate;
Figure 9 is a structural block diagram showing a sputtering apparatus according to Embodiments 4, 7, and 8 of the present invention;
Figure 10 is a sectional view showing a disk configuration of an optical recording medium according to Embodiment 4 of the present invention;
Figure 11 is a sectional view showing a disk configuration of an optical recording medium according to Embodiments 5, 6, and 8 of the present invention;
Figure 12 is a structural sectional view showing a vacuum film deposition chamber of the sputtering apparatus according to Embodiment 5 of the present invention;
Figure 13(a) is a sectional structural view showing the vacuum film deposition chamber according to the embodiment of the present invention;
Figure 13(b) is a plane structural diagram showing the vacuum film deposition chamber of the sputtering apparatus according to the embodiment of the present invention;
Figure 14(a) is a diagram showing a state of sputtering particles during film deposition in the sputtering apparatus according to the embodiment of the present invention;
Figure 14(b) is adiagramshowinga state of sputtering particles during film deposition in a conventional sputtering apparatus;
Figure 15 is a characteristic diagram showing the dependence of a CNR on the reproducing power of the optical disk when high-density recording and reproduction are performed by using the movement of a magnetic domain wall in the magneto-optical recording medium of the present invention;
Figure 16 is a structural block diagram showing a sputtering apparatus according to Embodiment 6 of the present invention;
Figure 17(a) is a sectional structural diagram showing a vacuum film deposition chamber in the sputtering apparatus according to Embodiment 6 of the present invention;
Figure 17(b) is a diagram showing the configuration of a target and an optical disk substrate in the sputtering apparatus of Embodiment 6;
Figure 18 is a sectional schematic diagram showing a state of magnetization on a recording film of an optical recording medium according to Embodiment 6 of the present invention;
Figure 19 is a characteristic diagram showing the dependence of a CNR on the recording power of the optical disk when high-density recording and reproduction are performed by using the movement of a magnetic domain wall in the magneto-optical recording medium of the present invention;
Figure 20(a) is a diagram showing the distribution of a carrier level in the circumferential direction of the optical disk when high-density recording and reproduction are performed by using the movement of a magnetic domain wall in the magneto-optical recording medium of the present invention;
Figure 20(b) is a characteristic diagram showing the distribution of a carrier level in the radius direction of the optical disk when high-density recording and reproduction are performed by using the movement of a magnetic domain wall in the magneto-optical recording medium of the present invention;
Figure 21 is a sectional view showing a disk configuration of an optical recording medium according to Embodiment 7 of the present invention;
Figure 22 is a characteristic diagram showing the dependence of a CNR on the modulated intensity of a recording magnetic field of the optical disk when high-density recording and reproduction are performed by using the movement of a magnetic domain wall in the magneto-optical recording medium of the present invention;
Figure 23 is a disk sectional view of an optical recording medium that shows the reproducing principle of MAMMOS system;
Figure 24 is a characteristic diagram showing the distribution of jitter in the radius direction of the optical disk;
Figure 25 is a characteristic diagram showing an amount of change in jitter in the disk when a ratio of a target diameter/disk diameter and a distance between the target and the substrate are changed;
Figure 26 is a diagram showing a state of sputtering particles during film deposition in the sputtering apparatus of Embodiment 6; and
Figure 27 is a sectional structural diagram showing a vacuum film deposition chamber of the conventional sputtering apparatus.

### (Description of Symbols)

- 1, 41, 101: Degassing chamber
- 2, 42, 102: Sealing chamber
- 3, 43, 103: Film deposition sputtering chamber
- 4, 44, 104: Loading chamber
- 5, 45, 105: Unloading chamber
- 7, 107: Substrate heating mechanism
- 10, 50, 110: Loading/unloading chamber
- 11 to 17: Vacuum film deposition chamber
- 51 to 59: Vacuum film deposition chamber
- 111 to 123: Vacuum film deposition chamber
- 20, 60, 130: Vacuum carrying chamber
- 21: Sputtering gas introducing port
- 23: Magnet
- 25: Cathode electrode
- 26: Substrate holder
- 27: Target
- 28: Optical disk substrate
- 29: Direct-current power supply
- 31: Shutter
- 24: Evacuation port
- 22, 33: Vacuum pump
- 135: Ion gun
- 20, 60, 130: Vacuum carrying chamber
- 201, 301, 401: Optical disk substrate
- 202, 302, 402: Dielectric layer
- 203, 303, 403: Reproduction layer
- 304, 404: Second reproduction layer
- 204, 305, 405: Control layer
- 205, 306, 406: Intermediate layer
- 206, 307, 407: Recording layer
- 207, 308, 408: Recording auxiliary layer
- 208, 309, 409: Dielectric layer
- 209, 310, 410: Overcoat layer
- 411: Sliding coat layer
- 412: Heat absorbing layer
- 607: Target
- 608: Optical disk substrate
- 611: Shielding plate

### Best Mode for Carrying Out the Invention

The following will describe embodiments of the invention of solving the first problem and/or the second problem in accordance with the accompanying drawings.

### (Embodiment 1)

The configuration of an optical recording medium (optical disk) will be described below according to an embodiment of the present invention.

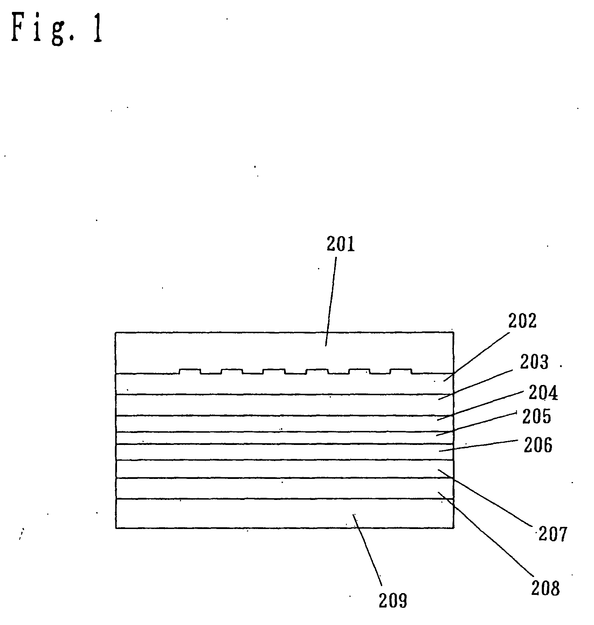

Figure 1 is a sectional view showing the configuration of the optical recording medium according to Embodiment 1.

As shown in FIG. 1, on an optical disk substrate 201, a recording film is formed via a dielectric layer 202 made of SiN. Here, the recording film is constituted of a reproduction layer 203 made of GdFeCoCr, a control layer 204 made of TbFeCo, an intermediate layer 205 made of TbFeCr, a recording layer 206 made of TbFeCoCr, and a recording auxiliary layer 207 made of GdFeCoCr. The recording film is formed with four magnetic thin films. Then, a signal recorded during recording is transferred to the reproduction layer via the intermediate layer and the control layer.

Further, a dielectric layer 208 made of SiN is laminated on the recording film and an overcoat layer 209 is formed thereon.

In the recording film, during reproduction of a signal, a recording magnetic domain of the recording layer of TbFeCoCr is magnetically coupled and transferred to the reproduction layer via the intermediate layer, and the reproduction layer in a light spot for reproduction is expanded and reproduced by the movement of the magnetic domain because the intermediate layer reaches the Curie temperature as the recording film increases in temperature and because the reproduction layer is small in magnetic domain wall coercive force in a temperature range equal to or higher than the Curie temperature.

Thus, in the recording magnetic layer, reproduction can be performed even on a small recording domain equal to or smaller than the limit of the light spot.

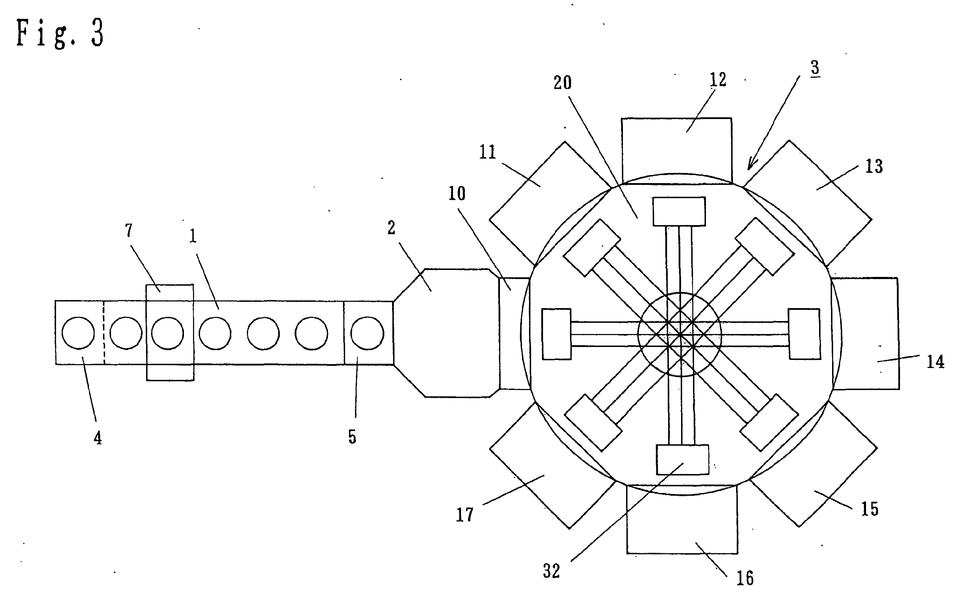

In the configuration of the optical recording medium according to the present embodiment, GdFeCoCr forming the reproduction magnetic film 203, TbFeCo forming the control layer 204, the intermediate layer 205 made of TbFeCr, TbFeCoCr forming the recording magnetic film 206, and the recording auxiliary layer 207 made of GdFeCoCr are laminated in sequence. When deposition is performed, targets corresponding to the respective compositions are provided in separate vacuum film deposition chambers 11 to 17 of Figure 3. The optical disk substrate is opposed to each of the targets, and the films are formed in sequence while the optical disk substrate is rotated on its axis.

The magneto-optical recording medium formed thus with the configuration according to Embodiment 1 of the present invention is applicable to a magneto-optical recording medium in which a magnetic domain walls reaching the light beam for reproduction are successively moved and the movement of the magnetic domain walls is detected, so that superresolution reproduction can be performed while exceeding a detection limit determined by a wavelength of reproduced light and a numerical aperture of the objective lens.

Additionally, the recording film laminated thus is an example of Domain Wall Displacement Detection (hereinafter, abbreviated as DWDD) which is a method of increasing a reproduction signal in amplitude by using the movement of a magnetic domain wall. Therefore, as described in Japanese Patent Laid-Open No. 6-290496, the configuration is applicable as long as a magnetic layer having a large interfacial saturated coercive force is used as a recording layer, a magnetic layer having a small interfacial saturated coercive force is used as a reproduction layer of moving a magnetic domain wall, a magnetic layer having a relatively low Curie temperature is used as a switching layer , and a magnetic f ilmpermitting the DWDD system is used. Therefore, the present invention is not limited to the above film configuration.

The reproducing principle of the magneto-optical recording medium using the DWDD system will be described below in accordance with the accompanying drawings.

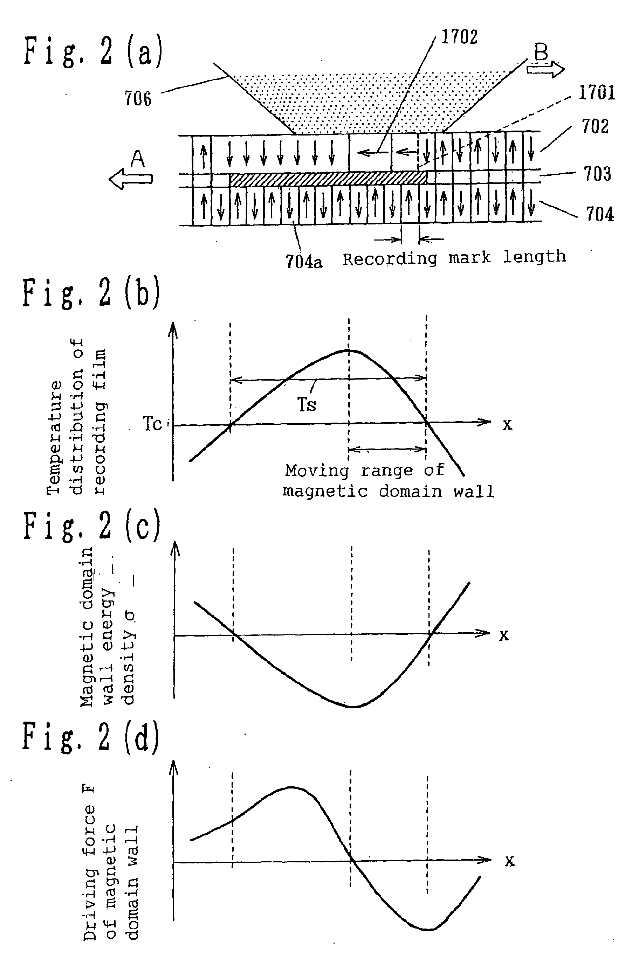

Figure 2(a) is a structural sectional view of the magneto-optical recording medium that shows the reproducing principle of the magneto-optical recording medium using the DWDD system.

As shown in the cross section of the recording film on the disk, which rotates in A direction of Figure 2(a), on the substrate 201 (Figure 1) and the dielectric layer 202, the medium has a recording film consisting of tree layers of a reproduction layer 702, an intermediate layer 703, and a recording layer 704. Further, a protective layer and a protective coating layer made of an ultraviolet curing resin are formed. Besides, in Figure 2(a), reference character B denotes the moving direction of a laser beam.

A magnetic film material having a small magnetic domain wall coercive force is used as the reproduction layer, a magnetic film having a low Curie temperature is used as the intermediate layer, and a magnetic film capable of storing a recording magnetic domain even with a small domain diameter is used as the recording layer.

In this configuration, the reproduction layer between recording tracks of the magneto-optical recording medium forms a guard band or the like, so that a magnetic domain structure including an unclosed magnetic domain wall is formed.

As shown in Figure 2(a), information signals are formed as recording magnetic domains 704a which are thermomagnetically recorded in the recording layer. In the recording film not being irradiated with a laser beam spot 706 at room temperature, the recording layer 704, the intermediate layer 703, and the reproduction layer 702 have strong exchange coupling. Thus, the recording magnetic domains 704a of the recording layer are transferred and formed as they are in the reproduction layer 702.

As shown in Figures 2(a) and 2(b), during reproduction of a recorded signal, the disk rotates (Figure 2) and the reproduction beam spot of a laser beam is emitted along the tracks.

At this point, the recording layer has a temperature distribution which peaks substantially at the center of the light spot (Figure 2(b)), a temperature area Ts is present where the intermediate layer reaches a Curie temperature Tc or higher, and exchange coupling is interrupted between the reproduction layer and the recording layer.

Moreover, when a reproduction beam is emitted, since a gradient of a magnetic domain wall energy density 6 is present in the X axis direction of the rotating direction of the disk (Figure 2(c)), force F of driving a magnetic domain wall 1701 is applied to magnetic domain walls in each of the layers at a position X on the X axis. An arrow (indicated by reference numeral 1702 in Figure 2(a)) from the right to the left in Figure 2(a) indicates that the force F is applied in a negative direction.

The force F applied to the recording film acts so as to move the magnetic domain wall 1701 to a lower magnetic domain wall energy ó (Figure 2(a) and Figure 2(d)). Since magnetic domain wall coercive force is small and the magnetic domain wall has large mobility in the reproduction layer, in the reproduction layer alone having the unclosed magnetic domain wall, the magnetic domain wall is readily moved by the force F.

Therefore, as indicated by a broken line, the magnetic domain wall 1701 of the reproduction layer instantly moves to an area having a higher temperature and a lower magnetic domain wall energy density. Then, when the magnetic domain wall passes through the reproduction beam spot, magnetization of the reproduction layer in the spot is aligned in the same direction over a wide area of the light spot.

As a result, regardless of the size of the recording domain wall, the amplitude of a reproduction signal is always equal to the constant maximum amplitude.

However, in the conventional magneto-optical recording medium of performing high-density recording and reproduction according to the DWDD system, it was not possible to form a reproduction layer, an intermediate layer, and a recording layer with high uniformity and quality in a disk while controlling exchange coupling among the laminated recording layers.

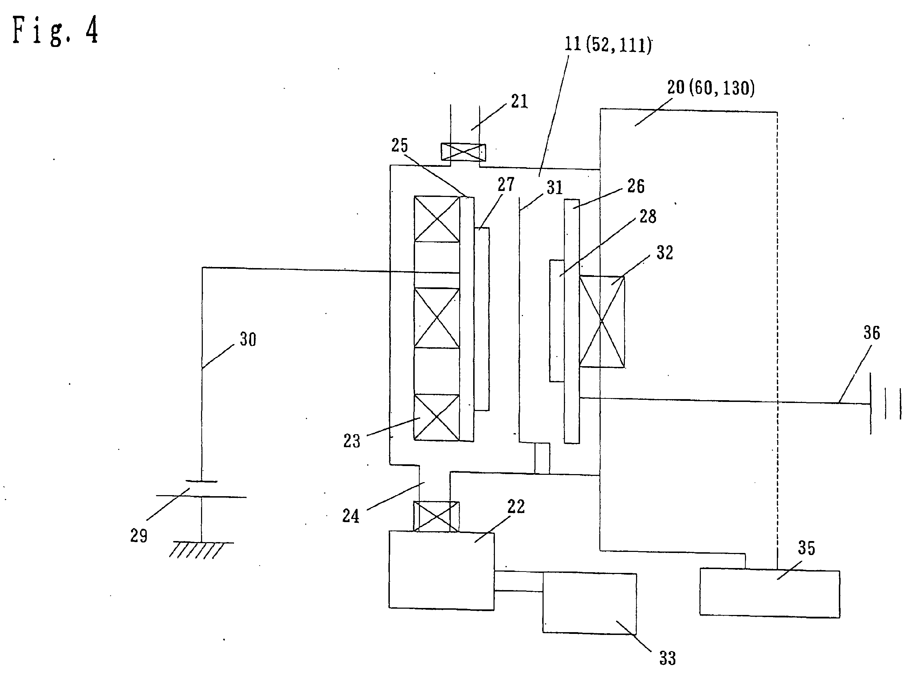

Referring to Figures 3 and 4, the following will describe a sputtering apparatus of manufacturing an optical recording medium which is an embodiment of another invention of the present invention.

As shown in Figure 3, the sputtering apparatus of manufacturing the optical recording medium serving as another invention of the present invention is constituted of a degassing chamber 1, a vacuum sealing chamber 2 for inert gas, and a film deposition sputtering chamber 3.

The degassing chamber is configured so that a substrate is fed into the degassing chamber 1 by a loading chamber 4 and is taken out from the degassing chamber 1 by an unloading chamber 5 for an optical disk substrate. The film deposition sputtering chamber 3 is constituted of a loading/unloading chamber 10, a plurality of vacuum film deposition chambers 11 to 17, and a vacuum carrying chamber 20 of carrying the substrate between the vacuum film deposition chambers.

In this configuration, the unloading chamber of the degassing chamber 1 and the loading/unloading chamber 10 of the film deposition sputtering chamber 3 are connected via the sealing chamber 2 filled with nitrogen gas of inert gas.

The following will describe a manufacturing process of the sputtering apparatus according to one embodiment, in a method of manufacturing the optical recording medium (optical disk) of the present invention.

Besides, the following explanation does not limit the relationship between the size of an optical disk radius D and a target radius a and the relationship between the arranged distances of the radiuses.

However, more uniform film characteristics can be obtained by satisfying the following conditions of these relationships as described above (e.g., Embodiments 5 and 6 and so on).

First, an optical disk substrate having prepits and grooves formed thereon is fed from the loading chamber 4 at a feeding port of the degassing chamber 1, and gas adsorbed on the optical disk substrate is removed while the substrate is moved in the degassing chamber. The degassed optical disk substrate is moved from the unloading chamber 5 of the degassing chamber through the sealing chamber 2 for inert gas in a short time, and the substrate is moved and carried into the film deposition sputtering chamber 3 from the loading/unloading chamber 10.

Besides, the conventional sputtering apparatus does not comprise the sealing chamber 2 for inert gas. For this reason, as described above, the configuration of the loading/unloading chamber has been made complicated to prevent oxidation on films.

In the present invention, as shown in Figure 3, the provision of the sealing chamber 2 makes it possible to prevent oxidation on films and shorten the tact time.

Particularly in the case of a high-density optical disk having a multilayer structure, oxidation caused by the entry of oxygen into a recording film has been a serious problem.

However, as described above, the provision of the sealing chamber 2 using inert gas makes it possible to suppress or prevent oxygen from entering into the recording film from the air in the present embodiment.

With this configuration, it is possible to achieve an optical disk with excellent recording film characteristics.

Subsequently, the movement to the vacuum film deposition chamber is performed by moving the optical disk substrate from the loading/unloading chamber 10 through the evacuated vacuum carrying chamber 20 to the vacuum film deposition chamber 11 (an example of step (a) of the present invention).

At this point, after evacuation is performed from atmospheric pressure, the loading/unloading chamber 10 is reduced in degree of vacuum in order to move the optical disk substrate, and the vacuum carrying chamber 20 is temporarily reduced in degree of vacuum due to the influence of the loading/unloading chamber when the optical disk substrate is moved from the loading/unloading chamber.

However, while the optical disk substrate is moved, the carrying chamber 20 is further evacuated by a turbo-molecular pump and then the optical disk substrate is moved into the vacuum film deposition chambers 11 to 17 kept at a high degree of vacuum (an example of step (d) of the present invention).

Here, as shown in Figure 4, the filmdeposition chamber of the sputtering apparatus comprises a sputtering gas introducing port 21, a turbo-molecular pump 22, and a vacuum evacuation port 24 which performs evacuation by using an oil-sealed rotary vacuum pump 33.

Further, in each of the vacuum film deposition chambers 11 to 17, a sputtering cathode 25 and a substrate holder 26 opposed to the sputtering cathode 25 are placed (an example of step (b) of the present invention). The substrate holder 26 is supported with a carrying mechanism 32 on the back, and uses the carrying mechanism 32 to move to the other vacuum film deposition chambers in sequence through the vacuum evacuation carrying chamber 20 (an example of step (d) of the present invention).

Further, when the optical disk is taken out from the apparatus after the recording film is deposited on the optical disk substrate, the following operation is performed: after the optical disk substrate is moved into the loading/unloading chamber 10 through the vacuum carrying chamber 20, nitrogen gas is introduced into the loading/unloading chamber 10, and the pressure is set at atmospheric pressure, the optical disk substrate is carried into the sealing chamber and taken out from a film deposition apparatus, and the film deposition process of the recording film (an example of step (c) of the present invention) is completed and advanced to the subsequent process.

In each of the vacuum film deposition chambers 11 and 17, a Si target 27 is mounted on the sputtering cathode 25 to deposit a dielectric film. On the back of the target 27, magnets 23 are arranged so as to generate a magnetic field on a surface of the target 27.

Similarly, in each of the vacuum film deposition chambers 12 to 16, a recording film target 28 is mounted on the sputtering cathode 24 to deposit a recording film. The magnets 23 on the back of the target 28 are arranged so as to generate a magnetic field on a surface of the target 28.

Furthermore, the sputtering cathode 25 is connected to a direct-current power supply 29 outside the vacuum film deposition chambers 11 to 17 so as to supply direct-current power to the cathode 25.

A shutter 31 is placed between the substrate holder 26 and the target 27 mounted on the sputtering cathode 25. Thus, when films for an optical recording medium is not deposited on an optical disk substrate 28, shielding is performed between the target 27 and the optical disk substrate 28 as necessary, and only when films for the optical recording medium is deposited, the shutter 31 is moved to permit deposition.

In the operation of the sputtering apparatus configured thus, Argon gas and nitrogen gas are introduced into the vacuum film deposition chamber 11 via the sputtering gas introducing port 21, evacuation is performed through the vacuum evacuation port 24, and an amount of introduced gas and an evacuating speed are controlled, so that a pressure in the vacuum film deposition chamber 11 is kept at 0.2 Pa.

In this way, after the inside of the vacuum film deposition chamber 11 is kept at the predetermined pressure, electric power is supplied to the Si target 27 mounted on the sputtering cathode 24 from the connected direct-current power supply 29, DC discharge is generated by the electric power, and a SiN film is formed on the optical disk substrate by reactive sputtering of Si.

Then, the optical disk substrate is moved through the vacuum carrying chamber 20, Argon gas is introduced into the vacuum film deposition chamber 12 via the sputtering gas introducing port 21, evacuation is performed through the vacuum evacuation port 24, and an amount of introduced gas and an evacuating speed are controlled, so that a pressure in the vacuum film deposition chamber 12 is kept at a pressure of 0.4 Pa.

In this way, after the inside of the vacuum film deposition chamber 12 is kept at the predetermined pressure, electric power is supplied to the recording film target 27 mounted on the sputtering cathode 25 from the connected direct-current power supply 29, and thus DC discharge is generated.

In this state, in the configuration using the shutter 31, the shutter is moved to open the position of shielding the optical disk substrate 28 and the target 27, so that an optical recording medium thin film of a target material is deposited on the optical disk substrate via the SiN film. In this process, the optical recording medium thin film is deposited on a part on the plastic substrate 28 other than a mask mounted and held on the substrate holder 26.

After the process is completed and discharge caused by sputtering is stopped or low discharged electric power is maintained by closing the shutter 31, the substrate holder 26 is moved by the carrying mechanism 32 from the position opposed to the target, and is carried to the subsequent vacuum film deposition chamber 13 through the vacuum carrying chamber 20 connected to the vacuum film deposition chamber 12.

In this way, on the position opposed to the target in each of the vacuum film deposition chambers 11 to 17, the optical disk substrate 28 for the deposition of the optical recording medium is mounted and held on the substrate holder 26 and is moved in sequence through the vacuum film deposition chambers to form the dielectric film and the recording film.

In this way, the optical recording medium is manufactured by using the manufacturing apparatus of the optical recording medium according to the present embodiment.

At this point, each of the magnetic films of the recording layer is carried and moved in carrying time of 6 seconds, and a sputtering film deposition velocity is adjusted so as to deposit and form the recording layers in sequence in deposition time of 3 seconds, so that one optical recordingmedium can be manufactured in 10 seconds or less.

Conventionally, there has been a problem in a method of using magnetically induced super-resolution to transfer a signal in a recording film to a reproducing magnetic film and reproduce the signal. That is, when the characteristics of the reproducing magnetic film are distributed, a signal quantity becomes uneven during reproduction particularly because of the characteristics of the interface of the recording film laminated in a multilayer structure.

Further, when the vacuum evacuation time is increased to stabilize the interface of the recording magnetic film, it is not possible to shorten film deposition time for each disk.

Furthermore, when the degassing chamber for degassing and the film deposition sputtering chamber are directly connected to each other, although time for degassing can be shortened, the unloading mechanism for taking out a disk from the apparatus becomes complicated or it takes long time to take out the disk. In any case, a serious problem has arisen in that the deposition time of the recording film is stably shortened to increase productivity.

On the other hand, the optical disk substrate is carried and moved to the film deposition sputtering chamber 3 from the degassing chamber 1 of the present invention through the inert gas sealing chamber 2 and is fed into the apparatus. Thus, it is possible to manufacture a recording film for each optical disk without the necessity for increasing time for degassing and film deposition. For this reason, stable interface characteristics are obtained between the laminated recording magnetic films, thereby achieving an excellent optical recording medium.

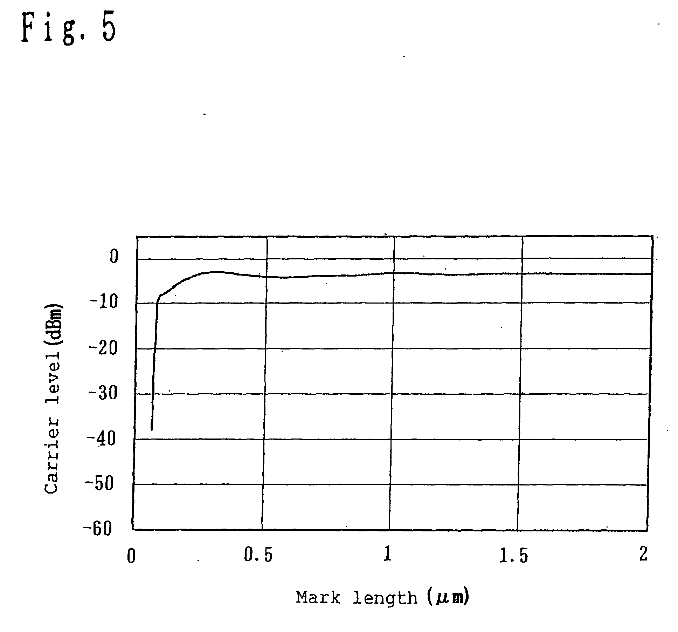

Figure 5 shows the dependence of a carrier level of a reproduction signal on a mark length when a signal is recorded and reproduced by modulating the intensity of a magnetic field while emitting a constant laser beam on the magneto-optical recording medium formed thus. As shown in Figure 5, it is understood that a reproduction signal can be obtained with substantially a constant carrier level and recording and reproduction can be performed with high density even when a mark length is 0.2 µm or smaller.

Moreover, when the characteristics of a bit error rate at this point are examined, the following results were obtained: the magneto-optical recording medium according to the embodiment of the present invention can have a CNR of 43 dB and a bit error rate of 1 × 10⁻⁴ or smaller even in the case of a recording magnetic field of 160 oe or smaller. Excellent characteristics are also obtained for the recording magnetic field.

As described above, in the magneto-optical recording medium and the manufacturing method thereof according to the present invention, the optical disk substrate is carried into the film sputtering chamber through the degassing chamber and the inert gas sealing chamber and thus a magneto-optical recording medium can be achieved with reduced film deposition tact and good signal quality by magnetron sputtering.

In this case, the film deposition time is set at 3 seconds, the carrying time is set at 6 seconds, and the film deposition waiting time is set at 1 second. Since the configuration delivers 35 optical disk substrates to the degassing chamber and moves the substrates to the film deposition sputtering chamber, the degassing chamber standby time is set at 350 seconds per disk. With this configuration, when the standby time in the degassing chamber is set at 300 seconds or more, the same or greater effect can be obtained, thereby achieving an optical recording medium with uniform film characteristics.

### (Embodiment 2)

The following will describe a magneto-optical recording medium and a manufacturing method thereof according to Embodiment 2.

The magneto-optical recording medium of Embodiment 2 has the same configuration as that of Figure 1. A plurality of recording films are formed on an optical disk substrate via a dielectric layer, the dielectric layer is subsequently laminated on the recording films, and an overcoat layer is formed thereon.

Further, as in the case of Embodiment 1, the configuration of a sputtering apparatus of manufacturing the optical recording medium according to Embodiment 2 will be described below in accordance with Figures 3 and 4.

As shown in Figure 3, as with Embodiment 1, the sputtering apparatus of manufacturing the optical recording medium according to another invention of the present invention is constituted of a degassing chamber 1, a sealing chamber 2 for inert gas, and a film deposition sputtering chamber 3.

In this configuration, the degassing chamber 1 of the present embodiment comprises a heating mechanism 7 for a substrate that uses an infrared lamp to accelerate vacuum degassing in the degassing chamber 1, in addition to a loading chamber 4 and an unloading chamber 5 of feeding and taking out an optical disk substrate into and from the degassing chamber 1. Thus, heating and degassing can be performed on the optical disk substrate in a vacuum.

Further, the film deposition sputtering chamber 3 is constituted of a loading/unloading chamber 10, a plurality of vacuum film deposition chambers 11 to 17, and a vacuum carrying chamber 20 for carrying the substrate between vacuum film deposition chambers. Here, the unloading chamber of the degassing chamber 1 and the loading/unloading chamber 10 of the film deposition sputtering chamber 3 are connected via a sealing chamber 2 filled with Ar gas as inert gas.

Then, the following will describe a manufacturing process in the sputtering apparatus of manufacturing the optical recording medium according to Embodiment 2 of the present invention.

First, an optical disk substrate having prepits and grooves formed thereon is fed from the loading chamber 4 at a feeding port of the degassing chamber 1, and gas adsorbed on the optical disk substrate is removed while the substrate is moved in the degassing chamber.

Here, the substrate heating mechanism 7 is mounted at some midpoint of the movement in the degassing chamber 1. Irradiation is performed by the infrared lamp at 1 kW for 4 seconds, so that the optical disk substrate is heated in a vacuum and discharge of gas from the substrate is accelerated. The substrate is moved through the sealing chamber 2 for inert gas from the unloading chamber 5 of the degassing chamber in a short time, and is carried and moved into the film deposition sputtering chamber 3 from the loading/unloading chamber 10.

Subsequently, the movement to the vacuum film deposition chamber is performed by moving the optical disk substrate from the loading/unloading chamber 10 to a vacuum film deposition chamber 11 through the evacuated vacuum carrying chamber 20.

At this point, since the optical disk substrate is moved from the loading/unloading chamber after evacuation is performed from atmospheric pressure, a degree of vacuum is low. When the optical disk substrate is moved from the loading/unloading chamber, the vacuum carrying chamber 20 for carrying the substrate is temporarily reduced in degree of vacuum due to the influence of the loading/unloading chamber.

However, during the movement of the optical disk substrate, the carrying chamber 20 is further evacuated by a turbo-molecular pump, and then, the optical disk substrate is moved to the vacuum film deposition chambers 11 to 17 which are kept at a higher degree of vacuum.

In this case, the film deposition process in the sputtering vacuum film deposition chamber is the same as that of Embodiment 1 and the detailed description thereof is omitted. After the recording films are deposited in the vacuum film deposition chamber, the substrate holder 26 is moved to the other vacuum film deposition chambers in sequence through the vacuum evacuation carrying chamber 20 by using a carrying mechanism 32 on the back.

After the recording films are deposited on the optical disk substrate, when the optical disk is taken out from the apparatus, the optical disk substrate is moved to the loading/unloading chamber 10 through the vacuum carrying chamber 20, Ar gas is introduced into the loading/unloading chamber 10, and a pressure is set at atmospheric pressure. Thereafter, the optical disk substrate is moved into the sealing chamber and taken out from the film deposition apparatus, so that the deposition process of the recording film is completed and is advanced to the subsequent process.

In this process , in the vacuum film deposition chamber 11 of the sputtering apparatus, Argon gas and nitrogen gas are introduced via the sputtering gas introducing port 21 and an evacuating speed of a vacuum evacuation pump through a vacuum evacuation port 24 is controlled, so that a pressure in the vacuum film deposition chamber 11 is kept at 0.3 Pa.

In this way, after the inside of the vacuum film deposition chamber 11 is kept at the predetermined pressure, electric power is supplied to a Si target 27 mounted on a sputtering cathode 25 from a connected direct-current power supply 29 , DC discharge is generated by the electric power, and a SiN film is formed on the optical disk substrate by reactive sputtering of Si.

Then, in each of the vacuum film deposition chambers 12 to 16 , the target 27 for depositing the optical recording medium is mounted on the sputtering cathode 25, and deposition is performed by moving the optical disk substrate through the vacuum chambers in sequence through the carrying chamber 20.

In the vacuum film deposition chamber 12, Argon gas is introduced via the sputtering gas introducing port 21, evacuation is performed by a vacuum pump through the vacuum evacuation port 24, and an amount of introduced gas and an evacuating speed are controlled, so that a pressure in the vacuum film deposition chamber 12 is kept at 0.6 Pa.

In this way, after the inside of the vacuum film deposition chamber 12 is kept at the predetermined pressure, electric power is supplied to the recording film target 27 mounted on the sputtering cathode 25 from the direct-current power supply 29, so that DC discharge is generated.

As a result, the optical recording medium thin film of a target material is deposited on the optical disk substrate via a SiN film. In this process, optical recording medium thin films are deposited in sequence on a part on the optical disk substrate 28 made of a plastic other than a mask mounted and held on the substrate holder 26.

Further, in the vacuum film deposition chamber 17, Argon gas and nitrogen gas are introduced and a pressure. in the vacuum film deposition chamber 11 is kept at 0.3 Pa. Thereafter, electric power is supplied from the direct-current power supply 29 to the Si target 27 mounted on the sputtering cathode 25, DC discharge is generated by the electric power, and a SiN film is formed on the optical disk substrate by reactive sputtering of Si.

In this way, on the position opposed to the target in each of the vacuum film deposition chambers 11 to 17, the optical disk substrate 28 for the deposition of the optical recording medium is mounted and held on the substrate holder 26, the substrate is moved in the vacuum film deposition chambers in sequence, and the dielectric film and the recording film are deposited.

As with Embodiment 1 of the present invention, the magneto-optical recording medium manufactured by using the manufacturing apparatus of such an optical recording medium has the structural sectional view of the magneto-optical recording medium shown in Figure 1.

Here, the optical recording medium of the present embodiment has a recording film formed on an optical disk substrate 201 via a dielectric layer 202 made of SiN with a thickness of 50 nm.

In this configuration, the recording film is constituted of five magnetic thin films: a reproduction layer 203 made of GdFeCoCr with a thickness of 30 nm, a control layer 204 made of TbFeCoCr with a thickness of 20 nm, an intermediate layer 205 made of TbFe with a thickness of 10 nm, a recording layer 206 made of TbFeCo with a thickness of 80 nm, and a recording auxiliary layer 207 made of GdFeCoCr with a thickness of 20 nm. The recording film is formed of the five magnetic thin films.

Then, a signal recorded in the recording layer is structurally transferred to the reproduction layer via the intermediate and the control layer. Further, the sputtering apparatus forms a configuration in which a dielectric layer 208 of SiN is laminated with a thickness of 60 nm on the recording film. On the SiN dielectric layer, an overcoat layer 209 is applied by spin coating and is cured by an ultraviolet curing resin.

Here, when a signal is reproduced, in the recording film, a recording magnetic domain of the TbFeCo recording layer is magnetically coupled and transferred to the reproduction layer via the intermediate layer, and the reproduction layer in a light spot for reproduction is expanded and reproduced by the movement of the magnetic domain wall because the intermediate layer reaches the Curie temperature as the recording film increases in temperature and because the reproduction layer is small in magnetic domain wall coercive force in a temperature range equal to or higher than the Curie temperature.

Thus, in the recording magnetic layer, reproduction can be performed even on a small recording domain equal to or smaller than the limit of the light spot.

At this point, the magnetic thin films of the recording film are carried and moved in a carrying time of 5 seconds, and a sputtering deposition velocity is adjusted so as to deposit and form the recording layers in sequence in a deposition time of 3.5 seconds, so that one optical recording medium can be manufactured in 10 seconds.

Conventionally, there has been a problem in a method of using magnetically induced super-resolution to transfer a signal in a recording film to a reproducing magnetic film and reproduce the signal. That is, when the characteristics of the reproducing magnetic film are distributed, a signal quantity becomes uneven during reproduction particularly because of the characteristics of the interface of the recording films laminated in a multilayer structure.

Further, when the vacuum evacuation time is increased to stabilize the interface of the recording magnetic film, it is not possible to shorten the deposition time for each disk.

Furthermore, when the degassing chamber for degassing and the film deposition sputtering chamber are directly connected to each other, although time for degassing can be shortened, an unloading mechanism for taking out a disk from the apparatus becomes complicated or it takes long time to take out the disk. In any case, a serious problem has arisen in that the deposition time of the recording film is stably shortened to increase productivity.

On the other hand, the optical disk substrate is carried and moved to the film deposition sputtering chamber 3 from the degassing chamber 1 of the present invention through the sealing chamber 2 filled with Ar gas as inert gas and is fed into the apparatus. At this point, by heating the optical disk substrate in the degassing chamber, it is possible to manufacture a recording film for each optical disk without the necessity for increasing time for degassing and film deposition.

Then, stable interface characteristics and its distribution are provided between the laminated recording magnetic films, thereby achieving an excellent optical recording medium.

Actually, in the case that a signal is recorded on the magneto-optical recording medium manufactured thus by modulating the intensity of a magnetic field while emitting a constant laser beam, when the characteristics of a recording and reproduction signal and the characteristics of a bit error rate are examined, the following results are obtained: even when a recording magnetic field is 180 oe or smaller, the magneto-optical recording medium according to the embodiment of the present invention can have a CNR of 44 dB and a bit error rate of 1 × 10⁻⁴ or smaller, and the characteristics for the recording magnetic field are excellent in the magneto-optical recording medium of the embodiment of the present invention.

As described above, in the magneto-optical recording medium and the manufacturing method thereof according to the present invention, the optical disk substrate is carried into the vacuum film deposition chamber through the degassing chamber and the inert gas sealing chamber and thus a magneto-optical recording medium which has accelerated film deposition tact and good signal quality can be achieved by magnetron sputtering.

In this case, the film deposition time is set at 3.5 seconds, the carrying time is set at 5 seconds, and the film deposition waiting time is set at 1 second. Since the degassing chamber comprises a substrate heating mechanism, the degassing effect on the substrate can be enhanced. Since the configuration delivers and carries 25 optical disk substrates to the vacuum film deposition chamber, degassing evacuation can be sufficiently performed for the optical disk substrate even when the degassing chamber standby time is 250 seconds for each disk. With this configuration, when the standby time is set at 200 seconds or more, the same or greater effect can be obtained, thereby achieving an optical recording medium with uniform film characteristics.

Moreover, conventionally, in a method of using the movement of a magnetic domain wall to expand a magnetic domain transferred to a reproducing magnetic film, since a transferred signal is reproduced while the magnetic domain wall is moved, a signal quantity during reproduction becomes uneven due to the distribution of characteristics of the reproducing magnetic film and changes in characteristics on the interface of the magnetic film.

On the other hand, in the present embodiment, during deposition of GdFeCoCr forming the reproducing magnetic film of the recording layer, TbFe forming the intermediate magnetic film, and TbFeCo forming the recording magnetic film, targets corresponding to the respective compositions are provided in the separate vacuum film deposition chambers 12 to 16, and the optical disk substrate is placed on a position opposed to the targets and is successively subjected to film deposition while being rotated on its axis. Additionally, degassing can be sufficiently performed on gas adsorbed on the optical disk substrate.

For this reason, in the optical recording medium according to Embodiment 2 of the present invention, even when a small recording domain is transferred to the reproducing magnetic film by moving a magnetic domain wall and is reproduced, a signal from the recording magnetic film can be transferred and reproduced with stability because of the uniform characteristics of the film having the moving magnetic domain wall.

As a result, in the optical recordingmedium according to Embodiment 2 of the present invention, even when a carrier level in a disk for a reproduction signal is distributed in a small recording domain which has a recording mark length of 0.4 µm, it is possible to achieve excellent characteristics of a signal amplitude change of 0.5 dB or less on one round of the disk and 1 dB or less in the radius direction.

### (Embodiment 3)

Embodiment 3 will be described below in accordance with the accompanying drawings.

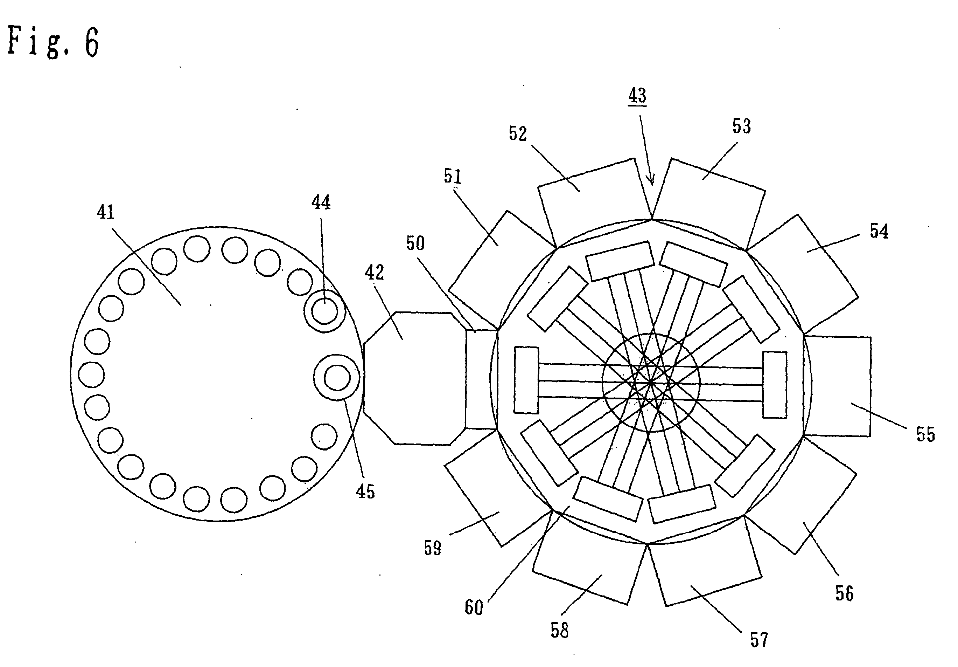

Figure 6 shows a sputtering apparatus of manufacturing an optical recording medium according to Embodiment 3, which is another invention of the present invention.

As shown in Figure 6, the sputtering apparatus of manufacturing the optical recording medium according to another invention of the present invention is constituted of a degassing chamber 41, a sealing chamber 42 for inert gas, and film deposition sputtering chamber 43.

As shown in Figure 6, the degassing chamber is reduced in required space because of its circular vacuum degassing chamber, and a substrate is fed and carried into the degassing chamber 41 by a loading chamber 44 and an unloading chamber 45 for an optical disk substrate.

Further, the film deposition sputtering chamber 43 is constituted of a loading/unloading chamber 50, a plurality of sputtering vacuum film deposition chambers 51 to 59, and a vacuum carrying chamber 60 of carrying a substrate between the vacuum film deposition chambers. The first vacuum film deposition chamber 51 comprises an ion gun instead of a cathode for sputtering.

The present embodiment is mainly different from the above embodiment in that the shape of the vacuum degassing chamber is circular and the first vacuum film deposition chamber 51 is additionally provided. Besides, the sputtering vacuum film deposition chambers 52 to 59 are similar in configuration to the vacuum film deposition chamber of Figure 4.

Here, the unloading chamber of the degassing chamber 41 and the loading/unloading chamber 60 of the film deposition sputtering chamber 43 are connected via the sealing chamber 42 filled with nitrogen gas of inert gas.

The following will describe the manufacturing process in the sputtering apparatus according to one embodiment, in a method of manufacturing an optical recording medium according to the present invention.

First, the optical disk substrate having prepits and grooves formed thereon is fed from the loading chamber 44 at a feeding port of the degassing chamber 41, and gas adsorbed on the optical disk substrate is removed while the substrate is moved in the circular degassing chamber. The degassed optical disk substrate is moved from the unloading chamber 45 of the degassing chamber through the sealing chamber 42 for inert gas in a short time, and the substrate is carried into the filmdeposition sputtering chamber 43 from the loading/unloading chamber 60.

Subsequently, the movement to the vacuum film deposition chamber is performed by moving the optical disk substrate to the vacuum film deposition chamber 51 from the loading/unloading chamber 50 through the evacuated carrying chamber 60.

At this point, since the loading/unloading chamber moves the optical disk substrate after evacuation from atmospheric pressure, a degree of vacuum is low. When the optical disk substrate is moved from the loading/unloading chamber, the vacuum carrying chamber 60 for carrying the substrate is temporarily reduced in degree of vacuum due to the influence of the loading/unloading chamber.

However, the timing when the optical disk substrate starts moving from the loading/unloading chamber to the carrying chamber is different from the timing when the substrate starts moving from the vacuum film deposition chamber for sputtering to the carrying chamber. The optical disk substrate firstly moves from the loading/unloading chamber to the carrying chamber.

In the present embodiment, the optical disk substrate starts moving from the loading/unloading chamber to the vacuum carrying chamber, and the substrate moves from the vacuum film deposition chamber to the vacuum carrying chamber two seconds later.

As a result, while the optical disk substrate is moved from the loading/unloading chamber to the carrying chamber, a degree of vacuum is temporarily reduced and a peak pressure is indicated. However, evacuation is immediately performed by a turbo-molecular pump of the carrying chamber 60, and the optical disk substrate is moved to the vacuum film deposition chambers 51 to 59 which are kept at a higher degree of vacuum.

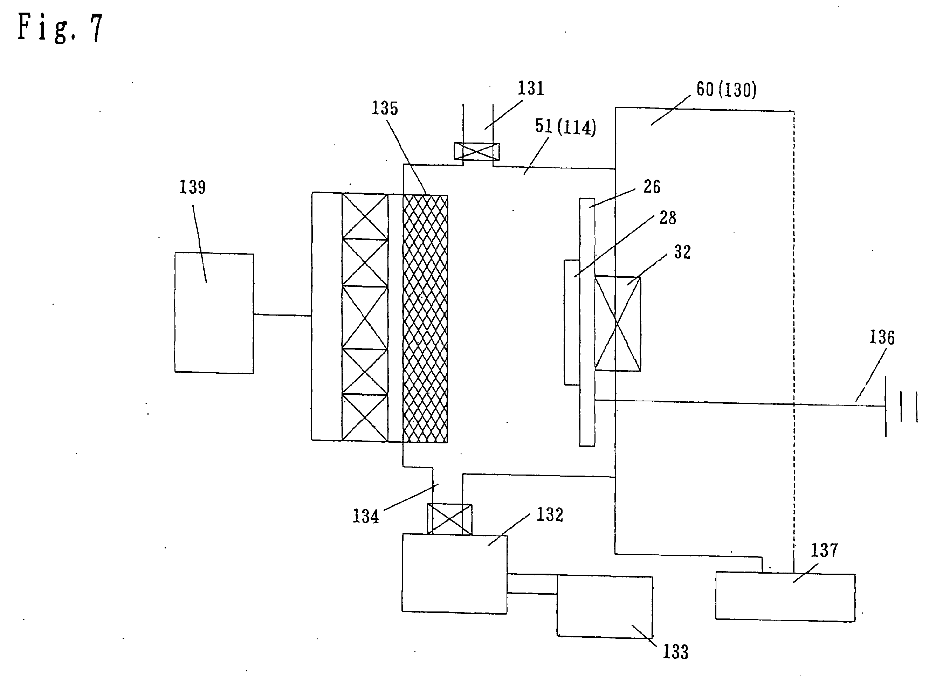

Here, as shown in Figure 7, the vacuum film deposition chamber 51 of the vacuum film deposition chambers 51 to 59 comprises a multi-source ion gun 135 for ion etching.

Further, a sputtering gas introducing port 131, a turbo-molecular pump 132, and a vacuum evacuation port 134 of performing evacuation using an oil-sealed rotary vacuum pump 133 are included.

Moreover, the optical disk substrate is mounted on a substrate holder 26 so as to be opposed to the ion gun 135, and the substrate holder 26 is moved by using a carrying mechanism 32 on the back to another vacuum film deposition chamber through the vacuum evacuation carrying chamber 60.

Additionally, the vacuum film deposition chambers 52 to 59 are similar in configuration to that of Figure 4, and each comprises a sputtering gas introducing port 21, a turbo-molecular pump 22, and a vacuum evacuation port 24 of performing evacuation using an oil-sealed rotary vacuum pump 33.

Further, in each of the vacuum film deposition chambers 52 to 59, a sputtering cathode 25 and the substrate holder 26 opposed to the sputtering cathode 25 are placed. The substrate holder 26 is supported with the carrying mechanism 32 on the back and is moved to the other vacuum film deposition chambers in sequence through the vacuum evacuation carrying chamber 60 by using the carrying mechanism 32.

Moreover, when the optical disk substrate is unloaded, the optical disk substrate is moved to the loading/unloading chamber 50 through the carrying vacuum chamber 60, nitrogen gas is introduced to the loading/unloading chamber 50, and a pressure is set at atmospheric pressure. Thereafter, the optical disk substrate is carried into the sealing chamber, the optical disk substrate is taken out from the film deposition apparatus, and the film deposition process of a recording film is completed and the substrate is advanced to the subsequent process.

In each of the vacuum film deposition chambers 53 to 57, an alloy target 27 for a recording film is mounted on the sputtering cathode 25 to perform deposition of an optical recording medium. On the back of the target 27, magnets 23 are arranged so as to generate a magnetic field on a surface of the target 27.

Similarly, a Si target 27 is mounted on the sputtering cathode 25 in each of the vacuum deposition chambers 52, 58, and 59, and the magnets 23 on the back of the target 27 are arranged so as to generate a magnetic field on the surface of the target 27.

Furthermore, the sputtering cathode 25 is connected to a direct-current power supply 29 outside the vacuum film deposition chambers 52 to 59, and direct-current power is supplied to the cathode 25.

Moreover, a shutter 31 is placed between the substrate holder 26 and the target 27 mounted on the sputtering cathode 25. When a thin film of an optical recording medium is not deposited on the optical disk substrate 28, shielding is performed between the target 27 and the optical disk substrate 28 as necessary. Only when the optical recording medium is deposited, the shutter 31 is moved to permit deposition.

In the operation of the sputtering apparatus configured thus, Argon gas is firstly introduced into the vacuum film deposition chamber 51 via the sputtering gas introducing port 131, evacuation is performed through the vacuum evacuation port 134, and an amount of introduced gas and an evacuating speed are controlled, so that a pressure in the vacuum film deposition chamber 51 is kept at 0.1 Pa.

In this way, after the inside of the vacuum film deposition chamber 51 is kept at the predetermined pressure, electric power of 300 W is applied to the ion gun with a voltage of 1500 V. Thus, Ar ions are generated and accelerated from the multi-source ion gun, and the ions are emitted onto the optical disk substrate, so that a surface of the optical disk substrate of polycarbonate undergoes ion etching.

Argon gas and nitrogen gas are introduced into the subsequent vacuum film deposition chamber 52 via the sputtering gas introducing port 21, evacuation is performed through the vacuum evacuation port 24, and an amount of introduced gas and an evacuating speed are controlled, so that a pressure in the vacuum film deposition chamber 52 is kept at 0.2 Pa.

In this way, after the inside of the vacuum film deposition chamber 52 is kept at the predetermined pressure, electric power is supplied to the Si target 27 mounted on the sputtering cathode 25 from a connected direct-current power supply 29, DC discharge is generated by the electric power, and a SiN film is formed on the optical disk substrate by reactive sputtering of Si.

Then, the optical disk substrate is moved to the subsequent vacuum film deposition chamber 53 through the vacuum carrying chamber 60, Argon gas is introduced into the vacuum film deposition chamber 53 via the sputtering gas introducing port 21, evacuation is performed through the vacuum evacuation port 24, and an amount of introduced gas and an evacuating speed are controlled, so that a pressure in the vacuum film deposition chamber 53 is kept at 0.6 Pa.

In this way, after the inside of the vacuum film deposition chamber 53 is kept at the predetermined pressure, electric power is supplied to the recording film target 27 mounted on the sputtering cathode 25 from the connected direct-current power supply 29, and thus DC discharge is generated.

In this state, in the configuration using the shutter 31, the shutter is moved to open the position of shielding the optical disk substrate 28 and the target 27, so that an optical recordingmedium thin film of a target material is deposited on the optical disk substrate via the SiN film. In this process, the optical recording medium thin film is deposited on a part other than a mask mounted and held on the substrate holder 26 on the plastic substrate 28.

After the process is completed and discharge caused by sputtering is stopped or small discharge electric power is maintained by closing the shutter 31, the substrate holder 26 is moved by the carrying mechanism 32 from the position opposed to the target 27, and is carried to the subsequent vacuum film deposition chamber 53 through the carrying vacuum chamber 60 connected to the vacuum film deposition chamber 53.

In this way, after Ar ions are emitted onto the optical disk substrate by the ion gun in the vacuum film deposition chamber 51, on the position opposed to the target in each of the vacuum film deposition chambers 52 to 59, the optical disk substrate 28 for the deposition of the optical recording medium is mounted and held on the substrate holder 26 and is moved in sequence through the vacuum film deposition chambers to get a dielectric film and the recording film deposited.

Additionally, in the above film deposition process, since the optical disk substrate is arranged directly above the position opposed to the target, the substrate holder for holding the optical disk substrate comprises a cooling mechanism using cooling water.

The following will describe the configuration of a magneto-optical recording medium which is manufactured by using such a manufacturing apparatus of the optical recording medium.

As with Figure 1, in the optical recording medium of the present embodiment, a recording film is formed on an optical disk substrate 201 via a dielectric layer 202 made of SiN.

Here, the recording film is constituted of a reproduction layer made of GdFeCoCr, a control layer made of TbFeCoCr, an intermediate layer made of TbFeCr, a recording layer made of TbFeCoCr, and a recording auxiliary layer made of GdFeCoCr. The recording film is formed of the five magnetic thin films. Further, a signal recorded in the recording layer is transferred to the reproduction layer via the intermediate layer and the control layer.

Moreover, a dielectric layer 208 of SiN is laminated on the recording film, and an overcoat layer 209 is formed thereon.

In this configuration, when a signal is reproduced, a recording magnetic domain of the TbFeCoCr recording layer is magnetically coupled and transferred to the reproduction layer via the intermediate layer, and the reproduction layer in a light spot for reproduction is expanded and reproduced by the movement of the magnetic domain wall because the intermediate layer reaches the Curie temperature as the recording film increases in temperature and because the reproduction layer is small in magnetic domain wall coercive force in a temperature range equal to or higher than the Curie temperature.

Thus, in the recording magnetic layer, reproduction can be performed even on a small recording domain equal to or smaller than the limit of the light spot.

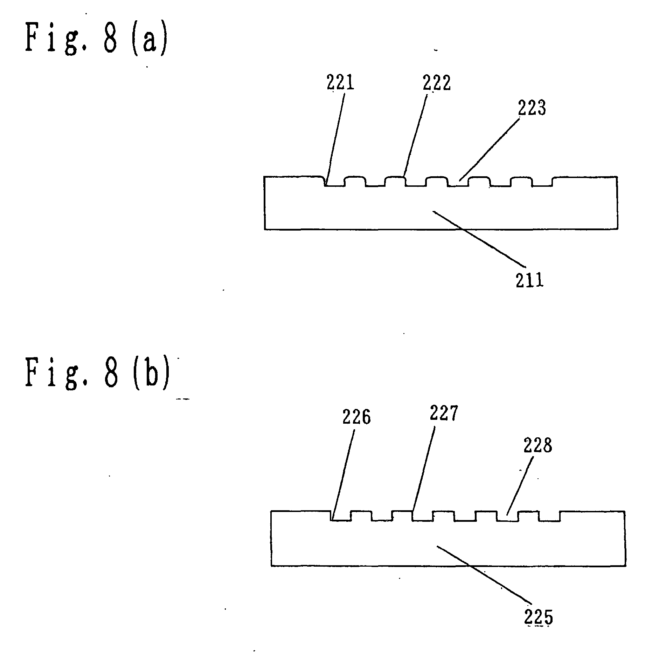

Here, the optical disk substrate of the magneto-optical recording medium according to Embodiment 3 of the present invention has a structural sectional view of an optical disk substrate shown in Figure 8(a).

In a method of transferring a signal in the recording layer to a reproducing magnetic layer and using the movement of a magnetic domain wall in the reproduction layer to perform expansion and reproduction, when the magnetic domain wall in the reproduction layer is moved with stability, the method is affected by the grooved shape of the optical disk substrate. As shown in the sectional view of Figure 8 (b) illustrating a conventional optical disk substrate 225, since edges 226 and 227 on a concave or convex part of a groove 228 result in irregularities, the movement of a magnetic domain wall in the reproduction magnetic layer becomes unstable.

On the other hand, as shown in Figure 8(a), regarding the grooved shape on the optical disk substrate 211 according to the embodiment of the present invention, edges 221 and 222 of a groove 223 are rounded without irreguralities by Ar ion etching. For this reason, in the method of transferring a signal in the recording layer to the reproduction layer and using the movement of a magnetic domain wall in the reproduction layer to perform expansion and reproduction,sincea reproduction magnetic domain can be formed by the stable movement of the magnetic domain wall, a signal quantity can be stabilized during reproduction.

As shown in Figure 8 (a) , the optical recording medium of the present embodiment is configured so that GdFeCoCr forming a reproducing magnetic layer 203, TbFeCoCr forming a control layer 204, TbFeCr forming an intermediate magnetic layer 205, TbFeCoCr forming a recording magnetic layer 206, and GdFeCoCr forming a recording auxiliary layer 207 are laminated in this order via a SiN film on the optical disk substrate 211 irradiated with Ar ions by an ion gun. Then, during film deposition, targets corresponding to the respective compositions are provided in the separate vacuum film deposition chambers 53 to 57, and the optical disk substrate is placed on positions opposed to the targets and is subjected to deposition in sequence while being rotated on its axis.

At this point, the respective magnetic films of the recording layer are carried and moved in carrying time of 3.5 seconds, and a sputtering film deposition velocity is adjusted so as to deposit and form the recording layers in sequence in deposition time of 5 seconds. Further, at this point, time to emit Ar ions for etching using the ion gun is adjusted at 6 seconds, so that one optical recording medium can be manufactured in 10 seconds.

Conventionally, in a method of using magnetically induced super-resolution and performing expansion and reproduction using the movement of a magnetic domain wall in the reproduction layer, when a magnetic domain wall is stably moved in the reproduction layer, in the case where the characteristics of the magnetic film are distributed, a signal quantity becomes uneven during reproduction particularly because of the characteristics of the interface on the recording film laminated in a multilayer structure.

Further, when the vacuum evacuation time is increased to stabilize the interface of the recording magnetic film, it is not possible to shorten the film deposition time for each disk.

Furthermore, when the degassing chamber for degassing and the vacuum film deposition chamber are directly connected to each other, although the time for degassing can be shortened, an unloading mechanism for taking out a disk becomes complicated or it takes long time to take out the disk. In any case, a serious problem has arisen in that the deposition time of the recording film is stably shortened to increase productivity.

On the other hand, the optical disk substrate is carried and moved to the film deposition sputtering chamber 43 from the degassing chamber 41 of the present invention through the inert gas sealing chamber 42 and is fed into the apparatus.

At this point, the optical disk substrate is subjected to surface treatment by the ion gun in the first vacuum film deposition chamber 51, so that unevenness caused by a change in degassing from the substrate can be suppressed. Thus, it is possible to stabilize the magnetic properties of the magnetic film without the necessity for increasing the time for degassing and film deposition.

As a result, the recording film can be formed for each optical disk and stable interface characteristics are achieved between the laminated recording magnetic films, thereby realizing an excellent optical recording medium.

In the method of transferring a signal in the recording film to the reproducing magnetic layer and performing expansion and reproduction using the movement of a magnetic domain wall in the reproduction layer, when the magnetic domain wall is stably moved in the reproduction layer, the grooved edges of the optical disk substrate are affected by irregularities. However, as shown in Figure 8(a), regarding the grooved shape of the optical disk substrate according to the embodiment of the present invention, the edge of the groove is rounded with small or no irregularities. For this reason, in the method of transferring a signal in the recording layer to the reproducing magnetic layer and performing expansion and reproduction using the movement of a magnetic domain wall in the reproduction layer, a reproduction magnetic domain can be formed by the stable movement of the magnetic domain wall. Thus, it is possible to stabilize a signal quantity, shorten the film deposition time for each disk, and ensure a high productivity.

Actually, in the magneto-optical recording medium manufactured thus, when a signal is recorded by modulating the intensity of a magnetic field while emitting a constant laser beam and the characteristics of a recording and reproducing signal and the characteristics of a bit error rate are examined, the following results were obtained: the magneto-optical recording medium according to the embodiment of the present invention can have a CNR of 44.5 dB and a bit error rate of 1 × 10⁻⁴ or smaller even in the case of a recording magnetic field of 170 oe or smaller, and characteristics for the recording magnetic field proved to be excellent.

As described above, in the magneto-optical recording medium and the manufacturing method thereof according to the present invention, the optical disk substrate is carried into the vacuum film deposition chamber through the degassing chamber and the inert gas sealing chamber, and deposition is performed by magnetron sputtering after performing ion etching on a surface of the optical disk substrate, so that a magneto-optical recording medium can be achieved with accelerated film deposition tact and excellent signal quality.

In this case, the ion etching time is set at 6 seconds, the film deposition time is set at 5 seconds, the carrying time is set at 3 seconds, and the film deposition waiting time is set at 1 second. Since the configuration delivers 20 optical disk substrates to the degassing chamber and moves the substrates to the vacuum film deposition chambers, the degassing chamber standby time is set at 200 seconds for each disk. With this configuration, when the standby time is set at 200 seconds or more, the same or greater effect can be obtained, thereby achieving an optical recording medium with uniform film characteristics.

### (Embodiment 4)

The following will describe a method of manufacturing an optical recording medium according to Embodiment 4 of the present invention with reference to the accompanying drawings.

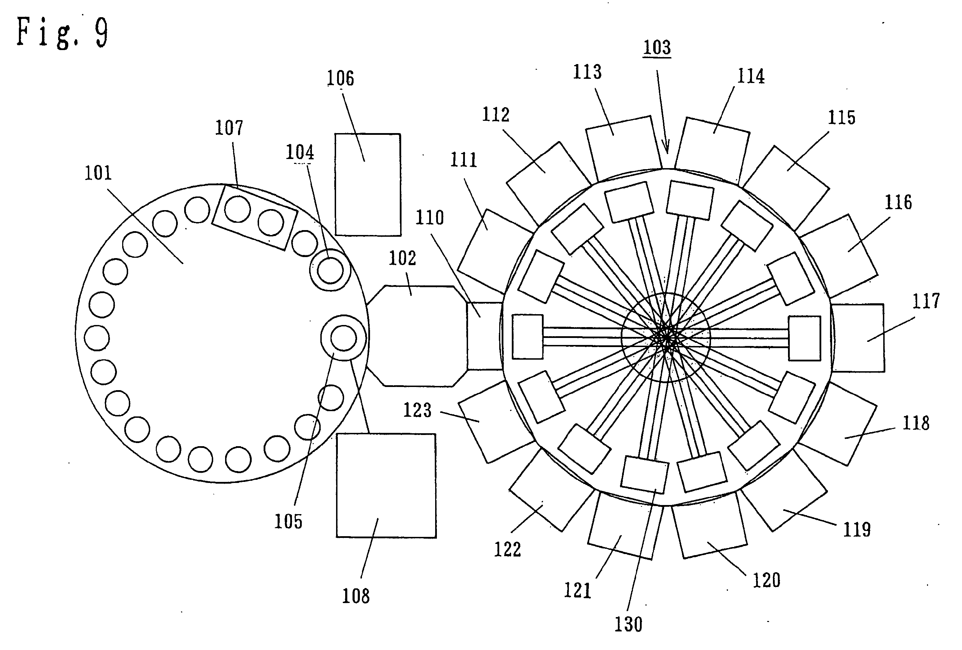

Figure 9 shows a sputtering apparatus of manufacturing the optical recording medium according to Embodiment 4 of the present invention. As shown in Figure 9, the sputtering apparatus of manufacturing the optical recording medium of the present invention is constituted of a degassing chamber 101, a sealing chamber 102 for inert gas, and a film deposition sputtering chamber 103.

As shown in Figure 9, the degassing chamber is reduced in required space due to the circular vacuum degassing chamber. A substrate is fed and carried into the degassing chamber 101 through a loading chamber 104 and an unloading chamber 105 for an optical disk substrate. In addition, a heating mechanism 107 using an infrared lamp is provided to perform vacuum degassing in the degassing chamber 1, thereby enabling heating and degassing on the optical disk substrate in a vacuum.

Further, the film deposition sputtering chamber 103 is constituted of a loading/unloading chamber 110, a plurality of sputtering vacuum film deposition chambers 111 to 123, and a vacuum carrying chamber 130 of carrying the substrate between the vacuum film deposition chambers. The fourth vacuum film deposition chamber 114 comprises an ion gun instead of a cathode for sputtering.

In this configuration, the unloading chamber of the degassing chamber 101 and the loading/unloading chamber 110 of the film deposition sputtering chamber 103 are connected to each other via the sealing chamber 102 filled with inert gas.

Moreover, the loading chamber 104 of the degassing chamber 101 is connected to a disk supply device 106. The optical disk substrate before film deposition carries a stocked optical disk substrate from the disk supply device 106 to the loading chamber 104 of the degassing chamber 101.

Further, the loading/unloading chamber 110 of the film deposition sputtering chamber 103 is connected to a disk stock device 108. Film-deposited magneto-optical recording mediums are carried from the loading/unloading chamber 110 of the film deposition sputtering chamber 103, and then, the recording mediums are moved to the disk stock device 108 and are stocked after being divided for each disk condition.

Next, the following will describe a manufacturing process performed by the sputtering apparatus in the method of manufacturing the optical recording medium according to Embodiment 4 of the present invention.

First, the optical disk substrate having prepits and grooves formed thereon is fed from the loading chamber 104 at a feeding port of the degassing chamber 101 from the disk supply device 106, and gas adsorbed on the optical disk substrate is removed while the substrate is moved in the circular degassing chamber.

In this configuration, the substrate heating mechanism 107 is mounted at some midpoint of the movement in the degassing chamber 101. Irradiation is performed by the infrared lamp at 0.8 kW for 6 seconds, so that the optical disk substrate is heated in a vacuum and discharge of gas from the substrate is accelerated. The substrate is moved through the sealing chamber 102 for inert gas from the unloading chamber 105 of the degassing chamber in a short time, and is carried and moved into the film deposition sputtering chamber 103 from the loading/unloading chamber 110.

Subsequently, the movement to the vacuum film deposition chamber is performed by moving the optical disk substrate from the loading/unloading chamber 110 to the vacuum film deposition chamber 111 through the evacuated carrying chamber 130.

At this point, since the optical disk substrate is moved from the loading/unloading chamber after evacuation from atmospheric pressure, a degree of vacuum is low. When the optical disk substrate is moved from the loading/unloading chamber, the vacuum carrying chamber 130 for carrying the substrate is temporarily reduced in degree of vacuum due to the influence of the loading/unloading chamber.

However, during the movement of the optical disk substrate, the carrying chamber 130 is further evacuated by a turbo-molecular pump, and then, the optical disk substrate is moved to the vacuum film deposition chambers 111 to 123 which are kept at a higher degree of vacuum.

As shown in Figure 7, in this configuration, the vacuum film deposition chamber 114 comprises an ion gun 135 for ion etching, a sputtering gas introducing port 131, a turbo-molecular pump 132, and a vacuum evacuation port 134 of performing evacuation using an oil-sealed rotary vacuum pump 133.

Further, the optical disk substrate 28 is mounted on the substrate holder 26 so as to be opposed to the ion gun, and the substrate holder 26 is moved by using a carrying mechanism 32 on the back to another vacuum film deposition chamber through the vacuum evacuation carrying chamber 130.

Moreover, each of the other vacuum film deposition chambers 111 to 113 and 115 to 123 comprises a sputtering gas introducing port 21, a turbo-molecular pump 22, and a vacuum evacuation port 24 of performing evacuation using an oil-sealed rotary vacuum pump 33.

Furthermore, the sputtering cathode 25 and the substrate holder 26 opposed to the sputtering cathode 25 are placed in the vacuum film deposition chamber. The substrate holder 26 is supported with the carrying mechanism 32 on the back and is moved to the other vacuum film deposition chambers in sequence through the vacuum evacuation carrying chamber 130 using the carrying mechanism 32.

Moreover, when the optical disk is taken out from the apparatus after the recording film is deposited on the optical disk substrate, the optical disk substrate is moved to the loading/unloading chamber 110 through the vacuum carrying chamber 130, nitrogen gas is introduced to the loading/unloading chamber 110, and a pressure is set at atmospheric pressure. Thereafter, the optical disk substrate is carried to the sealing chamber and is taken out from the film deposition apparatus, and the deposition process of the recording film is completed and the substrate is advanced to the subsequent process.

In each of the vacuum film deposition chambers 115 to 121, a target 27 is mounted on the sputtering cathode 25 to deposit an optical recording medium, and magnets 23 are placed on the back of the target 27 so as to generate a magnetic field on a surface of the target 27.

Similarly, an Si target 27 of depositing a dielectric film is mounted on the sputtering cathode 25 in each of the vacuum film deposition chambers 111, 112, 113, 122, and 123, the magnets 23 are similarly placed on the back of the Si target so as to generate a magnetic field on the surface of the target 27.

Furthermore, the sputtering cathode 25 is connected to a direct-current power supply 29 outside the vacuum film deposition chamber so as to supply direct-current power to the cathode 25. Besides, a shutter 31 is placed between the substrate holder 26 and the target 27 mounted on the sputtering cathode 25. When the optical recording medium is not deposited on the optical disk substrate 28, shielding is performed between the target 27 and the optical disk substrate 28 as necessary. Only when the optical recording medium is deposited, the shutter 31 is moved and opened to permit deposition.

In the operation of the sputtering apparatus configured thus, first, Argon gas and nitrogen gas are introduced into the vacuum film deposition chamber 111 via the sputtering gas introducing port 21, evacuation is performed through the vacuum evacuation port 24, and an amount of introduced gas and an evacuating speed are controlled, so that a pressure in the vacuum film deposition chamber 111 is kept at 0.4 Pa.

In this way, after the inside of the vacuum film deposition chamber 111 is kept at the predetermined pressure, electric power is supplied from the connected direct-current power supply 29 to the Si target 27 mounted on the sputtering cathode 25, DC discharge is generated by the electric power, and a SiN film is formed on the optical disk substrate by reactive sputtering of Si. Also in the vacuum film deposition chambers 112 and 113, a SiN film is deposited under the same conditions in order to shorten the film deposition time of SiN.

To the subsequent vacuum film deposition chamber 114, the substrate is moved through the carrying chamber 130. Argon gas is introduced into the vacuum film deposition chamber 114 via the sputtering gas introducing port 131, evacuation is performed through the vacuum evacuation port 134, and an amount of introduced gas and an evacuating speed are controlled, so that a pressure in the vacuum film deposition chamber 114 is kept at 0.08 Pa.

In this way, after the inside of the vacuum film deposition chamber 114 is kept at the predetermined pressure, electric power of 250 W is supplied to the ion gun. As a result, Ar ions are generated by the ion gun, and the ions are accelerated and emitted onto the optical disk substrate, and the SiN film on the optical disk substrate of polycarbonate is subjected to ion etching.

Further, the optical disk substrate is moved to the subsequent vacuum film deposition chamber 115 through the carrying chamber 130, Argon gas is introduced into the vacuum film deposition chamber 115 via the sputtering gas introducing port 21, evacuation is performed through the vacuum evacuation port 24, and an amount of introduced gas and an evacuating speed are controlled, so that a pressure in the vacuum film deposition chamber 115 is kept at 1.2 Pa.

In this way, after the inside of the vacuum film deposition chamber 115 is kept at the predetermined pressure, electric power is supplied from the connected direct-current power supply 29 to the recording film target 27 mounted on the sputtering cathode 25, so that DC discharge is generated.

In this state, in the configuration using the shutter 31, the shutter is moved and opened to open the position of shielding the optical disk substrate 28 and the target 27, so that an optical recording medium thin film of a target material is deposited on the SiN film having been subjected to ion etching on the optical disk substrate.

In this process, the optical recording medium thin film is deposited on a part other than a mask mounted and held on the substrate holder 26 on the optical disk substrate 28 made of a plastic.

After the process is completed and discharge caused by sputtering is stopped or low discharged power is maintained by closing the shutter 31, the substrate holder 26 is moved from the position opposed to the target by the carrying mechanism 32, and is carried to the subsequent vacuum film deposition chamber 116 through the carrying vacuum chamber 130 connected to the vacuum film deposition chamber 115.

In this way, after the dielectric film of SiN is deposited in each of the vacuum film deposition chambers 111, 112, and 113, Ar ions are emitted onto the SiN film on the optical disk substrate by using the ion gun in the vacuum film deposition chamber 114. Thereafter, on the position opposed to the target in each of the vacuum film deposition chambers 115 to 121, the optical disk substrate 28 of depositing the optical recording medium is mouthed and held on the substrate holder 26, is moved into the vacuum film deposition chambers in sequence, and thus the recording film is deposited.

Moreover, in the vacuum film deposition chambers 122 and 123, SiN of the dielectric film is deposited by reactive sputtering.

Additionally, in the above film deposition process, since the optical disk substrate is placed directly above the position opposed to the target, the substrate holder for holding the optical disk substrate comprises a cooling mechanism using cooling water.

The following will describe the configuration of a magneto-optical recording medium which is manufactured by using such a manufacturing apparatus of the optical recording medium.

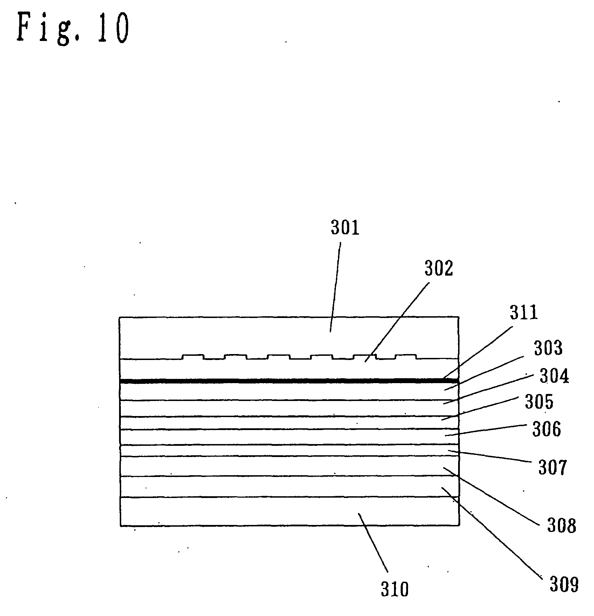

Figure 10 is a sectional view showing the configuration of the magneto-optical recording medium according to the embodiment of the present invention.

As shown in Figure 10, a recording film is formed on an optical disk substrate 301 via a dielectric layer 302 made of SiN.

Here, the recording film is constituted of a reproduction layer 303 made of GdFeCoAl, a second reproduction layer 304 made of GdFeAl, a control layer 305 made of TbFeCoAl, an intermediate layer 306 made of TbFeCoAl, a recording layer 307 made of TbFeCo, and a recording auxiliary layer 308 made of GdFeCoAl. The recording film is formed of the six magnetic thin films. Then, a signal recorded in the recording layer is transferred to the reproduction layer via the intermediate layer and the control layer.

Further, on the recording film, the dielectric layer 309 made of SiN is laminated, and an overcoat layer 310 is formed thereon.

At this point, an etching surface is formed on an interface of the dielectric layer 302 made of SiN on the side of the reproduction layer 303.

In this configuration, during reproduction of a signal, a recording magnetic domain of the TbFeCo recording layer is magnetically coupled and transferred to the reproduction layer via the intermediate layer, and the reproduction layer in a light spot for reproduction is expanded and reproduced by the movement of a magnetic domain wall because the intermediate layer reaches the Curie temperature as the recording film increases in temperature and because the reproduction layer is small in magnetic domain wall coercive force in a temperature range equal to or higher than the Curie temperature. Thus , in the recording magnetic layer, reproduction can be performed even in the case of a small recording domain equal to or smaller than the limit of the light spot.

At this point, on the optical recording medium of the present embodiment, the etching surface is formed on the interface of the dielectric layer 302 made of SiN on the side of the reproduction layer 303 and the medium has small irregularities on the surface. Thus, the movement of the magnetic domain wall is stabilized and excellent characteristics are obtained for a reproduction signal.

In the configuration of the optical recording medium according to the present embodiment, after Ar ions are emitted onto the optical disk substrate by the ion gun, GdFeCoAl forming the reproduction magnetic layer 303, GdFeAl forming the second reproduction magnetic layer 304, TbFeCoAl forming the control layer 305, TbFeCoAl forming the intermediate magnetic layer 306, TbFeCo forming the recording magnetic layer 307, and GdFeCoAl forming the recording auxiliary layer 308 are laminated insequenceviatheSiNfilm. Then, during film deposition, targets corresponding to the respective compositions are provided in the separate vacuum film deposition chambers 115 to 121, and the optical disk substrate is placed on a position opposed to the target and is successively subj ected to deposition while being rotated on its axis.

At this point, the respective magnetic films of the recording layer are carried and moved in carrying time of 4 seconds, and a velocity of sputtering film deposition is adjusted so as to deposit and form the recording layers in sequence in deposition time of 4.5 seconds. Further, at this point, time for Ar ion etching is set at 5 seconds by adjusting ion current by using the ion gun, so that one optical recording medium can be manufactured in 10 seconds or less.

Conventionally, in a method of using magnetically induced super-resolution and performing expansion and reproduction using the movement of a magnetic domain wall in the reproduction layer, when a magnetic domain wall is moved with stability in the reproduction layer, in the case where the characteristics of the magnetic film are distributed, a signal quantity becomes uneven during reproduction particularly because of the characteristics of an interface of the recording film laminated in a multilayer structure.

Moreover, when the vacuum evacuation time is increased to stabilize the interface of the recording magnetic film, it is not possible to reduce the film deposition time for each disk.

Furthermore, when the degassing chamber for degassing and the vacuum film deposition chamber are directly connected to each other, although the time for degassing can be shortened, an unloading mechanism for taking out a disk from the apparatus becomes complicated or it takes long time to take out the disk. In any case, a serious problem has arisen in that the deposition time of the recording film is stably shortened to increase productivity.

On the other hand, the optical disk substrate is carried and moved to the film deposition sputtering chamber 103 from the degassing chamber 101 of the present invention through the inert gas sealing chamber 102 and is fed into the apparatus.

At this point, after the SiN film is deposited on the optical disk substrate, the SiN film of the optical disk substrate is subjected to surface treatment in the vacuum film deposition chamber 114, so that unevenness caused by a change in degassing from the substrate can be suppressed and surface properties can be improved. Thus, it is possible to stabilize the magnetic properties of the magnetic film without the necessity for increasing the time for degassing and film deposition.

As a result, the recording film can be manufactured for each optical disk and stable interface characteristics are provided between the laminated recording magnetic films, thereby achieving an excellent optical recording medium.

Additionally, in the method of transferring a signal in the recording film to the reproduction magnetic film and performing expansion and reproduction using the movement of a magnetic domain wall in the reproduction layer, when the magnetic domain wall is stably moved in the reproduction layer, the movement of the magnetic domain wall in the reproduction magnetic film becomes unstable due to the influence of the surface state during the film deposition of the reproduction layer.

On the other hand, as shown in Figure 10, regarding the optical recording medium according to the embodiment of the present invention, after the dielectric film of SiN is deposited, an even state can be obtained by ion etching before the deposition of the recording film, and with the method of transferring a signal in the recording film to the reproduction magnetic film and performing expansion and reproduction using the movement of a magnetic domain wall in the reproduction layer, a reproduction magnetic domain can be formed by the stable movement of the magnetic domain wall. Hence, it is possible to stabilize a signal quantity during reproduction. In addition, it is possible to shorten film deposition time for each disk and ensure productivity.

Actually, in the case where a signal is recorded by modulating the intensity of a magnetic field while emitting a constant laser beam on the magneto-optical recording medium manufactured thus, the characteristics of a recording and reproducing signal and a bit error rate are examined and the following results were obtained: the magneto-optical recording medium according to the embodiment of the present invention can have a CNR of 44.5 dB and a bit error rate of 9 × 10⁻⁵ or smaller even in the case of a recording magnetic field of 150 oe or smaller, and characteristics for a recording magnetic field proved to be excellent.

As described above, in the magneto-optical recording medium and the manufacturing method thereof according to the present invention, the optical disk substrate is carried into the vacuum film deposition chamber through the degassing chamber and the inert gas sealing chamber, film deposition is performed by magnetron sputtering after performing ion etching on a surface of the SiN film on the optical disk substrate, so that a magneto-optical recording medium can be achieved with accelerated film deposition tact and excellent signal quality.

In this case, the ion etching time is set at 5 seconds, the film deposition time is set at 4.5 seconds, the carrying time is set at 4 seconds, and the film deposition waiting time is set at 1 second. Since the configuration delivers 25 optical disk substrates to the degassing chamber and moves the substrates to the vacuum film deposition chamber, the degassing chamber standby time is set at 250 seconds for each disk. With this configuration, when the standby time is set at 200 seconds or more, the same or greater effect can be obtained and thus an optical recording medium is achieved with uniform film characteristics.

The present embodiment described etching performed only on the optical disk substrate or etching performed only on the surface of the SiN film. A method of combining both of the etching and adjusting the respective etching conditions is also applicable.

Further, the above embodiment described that the target 27 opposed to the optical disk substrate 28 is one. Even when a plurality of targets having the same composition or having differentmaterials or compositions are opposed to the optical disk substrate, the same effect can be obtained as long as at least the degassing chamber and the film deposition sputtering chamber are connected to each other via the sealing chamber filled with inert gas and the ion gun is placed in the vacuum film deposition chamber.

### (Embodiment 5)

Embodiment 5 of the present invention will be described below in accordance with the accompanying drawings.

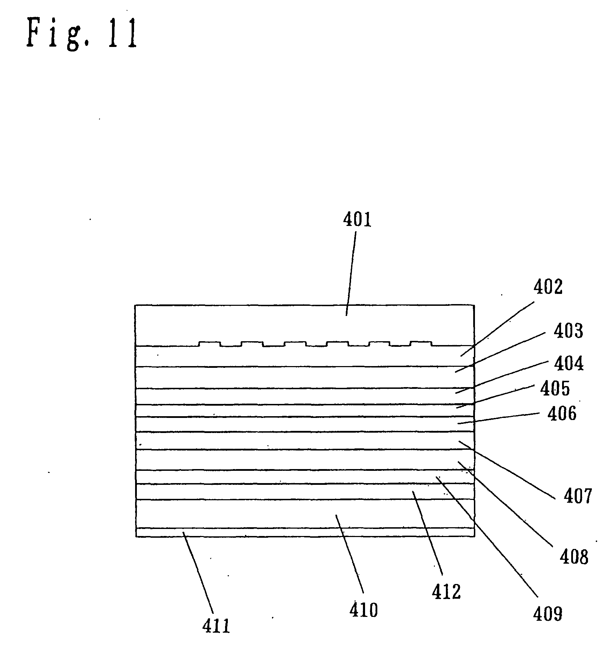

Figure 11 is a sectional view showing the configuration of a magneto-optical recording medium according to Embodiment 5 of the present invention.

As shown in Figure 11, on an optical disk substrate 401, a reproduction layer 403 made of GdFeCo, a second reproduction layer 404 made of GdFeCoCr, a control layer 405 made of TbFeCoCr, and an intermediate layer 406 made of TbFeCr, each of which is a magneto-optical recording medium material, are formed in sequence via a dielectric layer 402 made of SiN.

Further, a recording layer 407 made of TbFeCoCr and a recording auxiliary layer 408 made of GdFeCoCr are formed thereon, an intermediate dielectric layer 409 made of SiN is laminated thereon, and an overcoat layer 410 is formed thereon. Additionally, a sliding coat layer 411 is applied and formed on the overcoat layer 410.

As in the case of Embodiment 1, a method of increasing and reproducing a reproduction signal is used for the magneto-optical recording medium formed thus, according to a magnetic domain expansion method using the movement of a magnetic domain wall.

A method of manufacturing an optical recording medium of the present invention will be described below in accordance with the accompanying drawings.

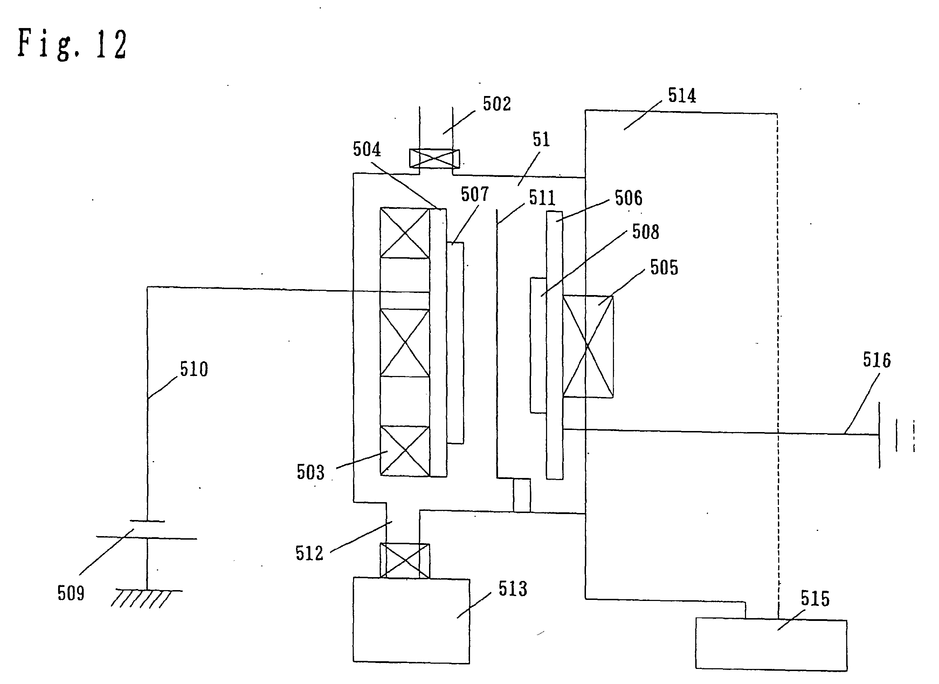

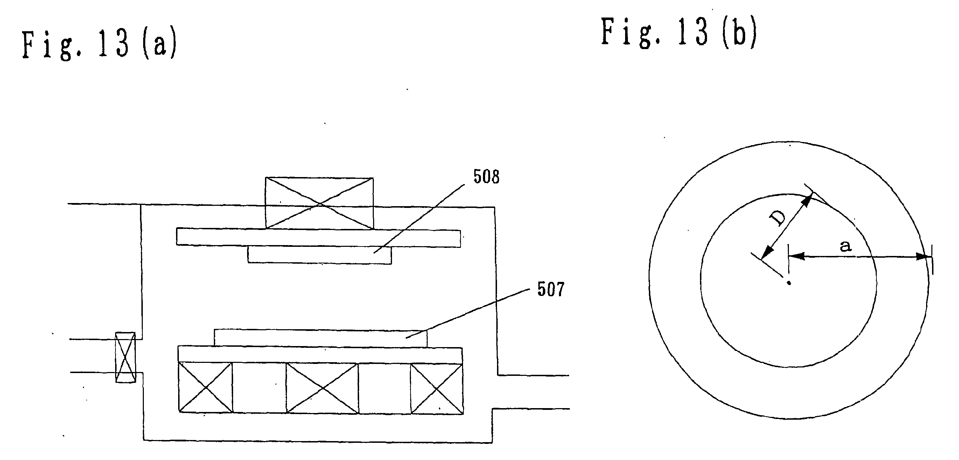

A sputtering apparatus of manufacturing the optical recording medium of the present embodiment comprises nine vacuum film deposition chambers as with Embodiment 3 shown in Figure 6. Regarding the vacuum film deposition chamber of the sputtering apparatus of manufacturing the optical recording medium according to the embodiment or the present invention, the configuration of Figure 12 is provided. The relationship between the substrate and a target for a recording film is shown in the sectional structural view of Figure 13(a) and a plan structural view of Figure 13(b).

As shown in Figures 12 and 13, a vacuum film deposition chamber 51 of the sputtering apparatus comprises a sputtering gas introducing port and a vacuum evacuation port for vacuum evacuation using a vacuum pump.

An optical disk substrate 508 is carried into the vacuum chamber 51 (an example of step (a) of the present invention). Further, in the vacuum film deposition chamber 51, a sputtering cathode 504 and a substrate holder 506 opposed to the sputtering cathode 504 are placed (an example of step (b) of the present invention).

The substrate holder 506 is supported with a carrying mechanism 505 on the back. When the substrate is carried into another vacuum film deposition chamber, the carrying mechanism is used and the substrate is carried into another vacuum film deposition chamber through a vacuum carrying chamber 514 connected to the vacuum film deposition chamber 51 (an example of step (d) of the present invention).

The film-deposited optical disk substrate is moved to a loading/unloading chamber from the vacuum carrying chamber 514 and is taken out to the air.

A target 507 made of a magneto-optical recording medium material is mounted on the sputtering cathode 504, and magnets 503 are placed on the back of the target 507 so as to generate a magnetic field on a surface of the target 507.

Moreover, the optical disk substrate 508 of depositing the optical recording medium is mounted on the substrate holder 506 opposed to the target.

Here, the target 507 has a radius *a* of 63 mm and the optical disk substrate 508 has a radius D of 28 mm, which satisfies the relationship of *a* > 2 x D. Additionally, a distance between the target and the substrate is 40 mm.

In the vacuum film deposition chamber, a shutter 511 is placed between the substrate holder 506 and the target 507 mounted on the sputtering cathode 504. When the optical recording medium is not deposited on the optical disk substrate 508, shielding is performed between the target 507 and the optical disk substrate 508. Only when the optical recording medium is deposited, the shutter 511 is moved and opened to permit film deposition.

In the operation of the sputtering apparatus configured thus, sputtering gas such as Argon gas is introduced into the vacuum film deposition chamber 51 via a sputtering gas introducing port 502, evacuation is performed through a vacuum evacuation port 512, and an amount of introduced gas and an evacuating speed are controlled, so that a pressure in the vacuum film deposition chamber 51 is kept at an arbitrary value between 0.1 Pa and 10 Pa.

In this way, after the inside of the vacuum film deposition chamber 51 is kept at a predetermined pressure, and electric power is supplied from a connected direct-current power supply 509 to the target 507 mounted on the sputtering cathode 504, so that DC discharge is generated (an example of step (c) of the present invention). The sputtering cathode 504 is connected to the direct-current power supply 509 outside the vacuum film deposition chamber 51, and the supply of direct-current power to the cathode 504 can be set by a computer for control.

In the magneto-optical recording medium according to the embodiment of the present invention, as shown in Figure 11, the reproduction layer, the second reproduction layer, the control layer, the intermediate layer, the recording layer, and the recording auxiliary layer are formed on the optical disk via the dielectric layer. Further, the dielectric layer is sequentially laminated on the recording film, and the overcoat layer and the sliding coat layer are formed thereon.

With this configuration, a signal transferred from the recording layer to the reproduction layer is reproduced by expanding a transfer magnetic domain up to a region where the control layer and the intermediate layer reach a Curie temperature or higher. Thus, even a small recording domain can be reproduced in a recording magnetic layer.

However, conventionally, in the method of using the movement of a magnetic domain wall to expand a magnetic domain transferred to the reproduction layer, when the characteristics of a reproduction magnetic film are distributed, a transferred signal is reproduced while the magnetic domain wall is moved. Thus, a signal quantity becomes uneven during reproduction.

In the method of manufacturing the optical recording medium according to the present embodiment, a radius *a* of the target and *a* radius D of the optical disk substrate satisfy the relationship of *a* > 2 x D. Thus, each of the recording films in the optical disk substrate has uniform magnetic properties because a target area is sufficiently large relative to an area of the optical disk substrate.

Moreover, in the present embodiment, the reproduction layer 403 made of GdFeCo, the second reproduction layer 404 made of GdFeCoCr, the control layer 405 made of TbFeCoCr, the intermediate layer 406 made of TbFeCr, the recording layer 407 made of TbFeCoCr, and the recording auxiliary layer 408 made of GdFeCoCr are successively deposited while being rotated on its axis while targets corresponding to the respective compositions are placed in separate vacuum film deposition chambers, and the optical disk substrate is placed on a position opposed to the target.

At this point, while turning on/off of sputtering discharge is repeated, a magnetic film having a thickness of 5 nm is laminated by sputtering as the intermediate layer 406 having a thickness of 20 nm and a magnetic film having a thickness of 5 nm is laminated by sputtering as the recording layer 407 having a thickness of 80 nm.

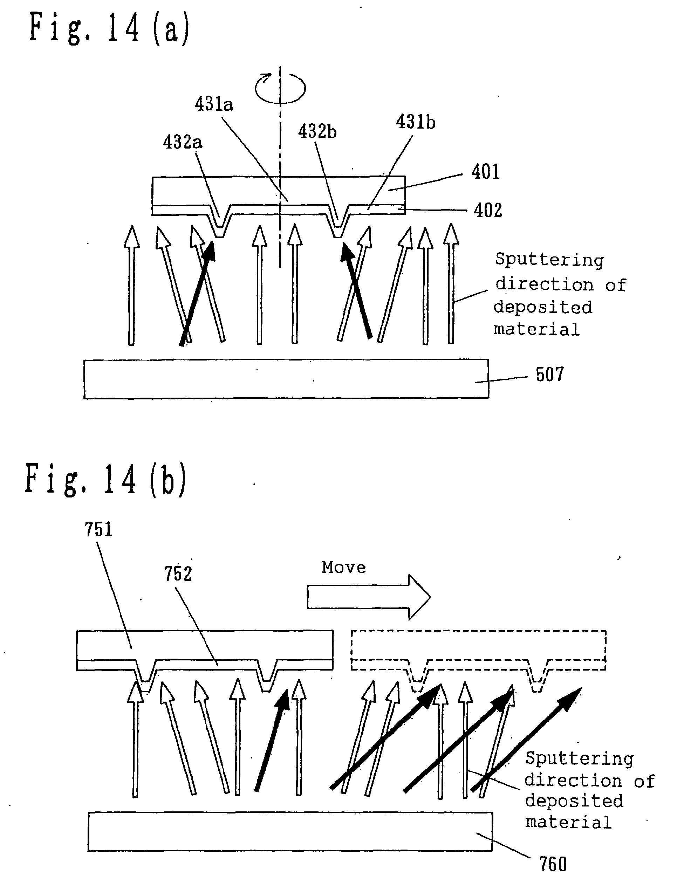

The following explanation describes comparison with the conventional film deposition method. As shown in Figure 14(b), in the sputtering apparatus of a conventional passing system, as indicated by arrows in Figure 14(b), sputtered particles with various angles are formed from a target 760 onto an optical disk substrate 751 or via a dielectric layer 752. For this reason, in a groove, a magnetic film is formed up to its tilted part with the same characteristics as at the bottom of the groove.

At this point, in the case where the optical disk substrate revolves and rotates on its axis (that is, revolves while rotating on its axis), passage is performed many times above the same target so as to make a laminated state and thus the magnetic anisotropy of the recording film tends to improve.

However, in such a conventional configuration, since an optical disk needs to be revolved and moved, productivity is reduced.

Meanwhile, in the film deposition apparatus of the present embodiment, the optical disk substrate 401 is placed on the position opposed to the target 507, and as described above, the relationship of D > 2*a* is established. Thus, it is possible to form films with uniform magnetic properties with high productivity.

However, as shown in Figure 14(a), since the films are formed directly above the others in one direction, the film has large internal stress, and magnetic anisotropy perpendicular to the film surface tends to decrease. Here, on the optical disk substrate 401, grooves 431a and 431b and lands 432a and 432b are formed on each recording track.

Hence, in order to improve the above tendency, in addition to the above configuration, the present invention is configured so that at least the film structure of the recording layer is formed as a small layered structure by using the direct-current power supply to repeat alternately conduction and non-conduction to the target.

With this configuration, the recording layers are laminated and deposited as small layers on the optical disk substrate. The laminated intermediate layer and recording layer make it possible to obtain magnetic properties enough to perform recording and reproduction with high density even in the case of a film deposition method having opposed targets.

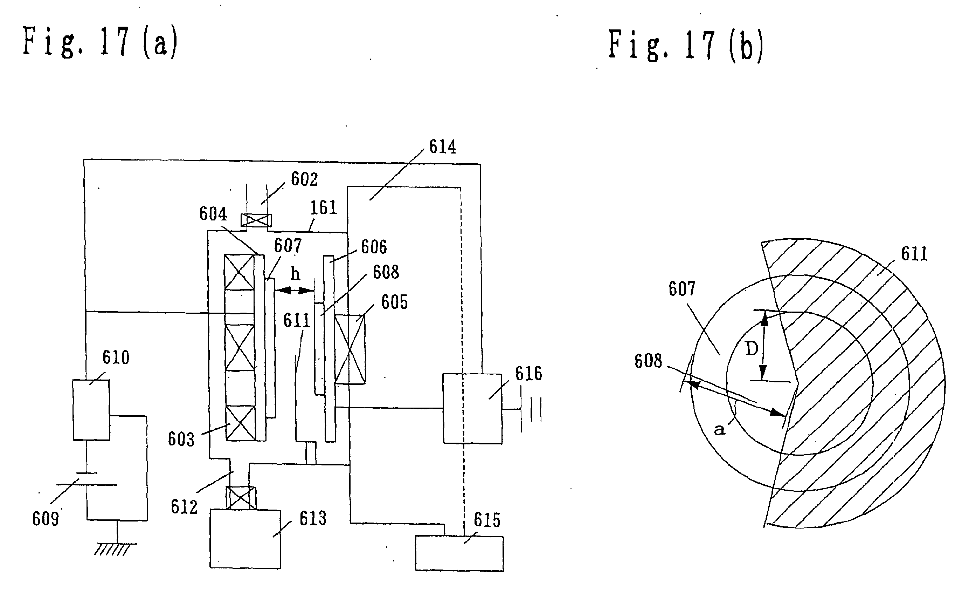

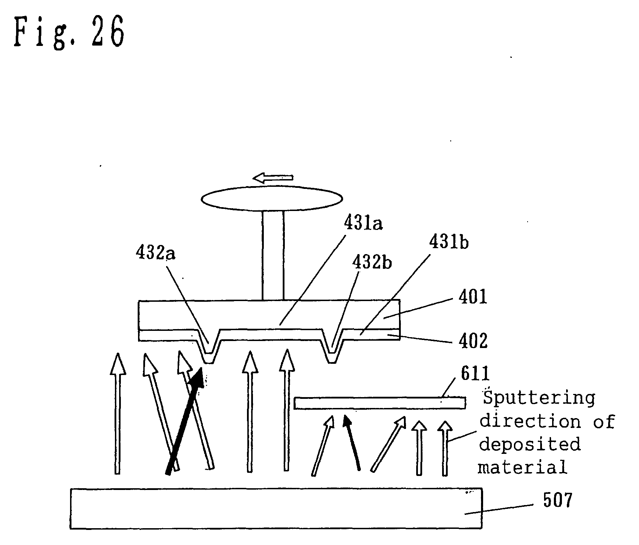

Additionally, another method of forming a film structure into a small layered structure will be described below (Figure 17(a), Figure 17(b), and Figure 26).

With this method, the recording film increases in magnetic anisotropy perpendicularly to the film surface, and recording can be performed with high density. Further, the film can be reduced in internal stress, and thus excellent signal quality and reliability can be obtained.

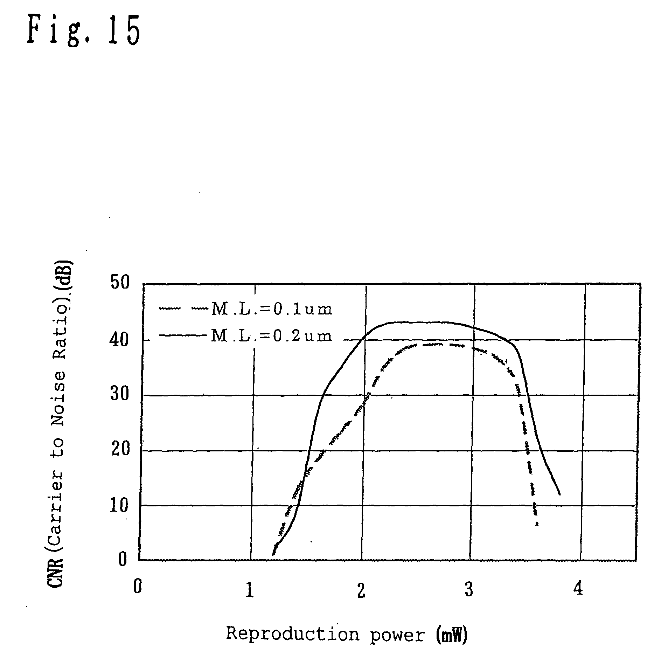

Actually in the magneto-optical recording medium of the present embodiment, deposition of 5 nm is performed in a laminated manner by DC sputtering when the intermediate layer 406 and the recording layer 407 are manufactured. Figure 15 shows the characteristics of a carrier during the reproduction of a signal when the magneto-optical recording medium manufactured thus is changed in reproducing power. As indicated by solid line of Figure 15, it is found that in the magneto-optical recording medium of the present invention, a signal with a mark length of 0.2 µm can obtain a CNR of 43 dB and a reproduction signal is not reduced when a reproducing power margin is ±10% or higher. Further, even with a mark length of 0.1 µm indicated by a broken line, a CNR of 39 dB is obtained with excellent characteristics of a recording and reproduction signal.

It is assumed that because the intermediate layer 406 and the recording layer 407 formed by the manufacturing method of the present embodiment are laminated with periodicity in a fine structure, pinning is less likely to occur on a magnetic domain wall due to the uneven magnetic domain structure of the recording film, a stable recording domain is formed even in a small recording magnetic domain when a signal is recorded, and transfer can be stably performed from the recording layer 407 to the reproduction layer 403 when a signal is reproduced.

In this way, in the magneto-optical recording medium and manufacturing method of the present invention, the recording film periodically laminated as a fine laminated structure makes it possible to achieve an excellent magneto-optical recording medium.

### (Embodiment 6)

The following will describe a magneto-optical recording medium and a manufacturing method thereof according to Embodiment 6 of the present invention.

Also in Embodiment 6, an optical recording medium has the same configuration as that of Figure 11. A reproduction layer 403 made of GdFeCoCr, a reproduction layer 404 made of GdFeCr, a control layer 405 made of TbFeCoCr, an intermediate layer 406 made of TbFeCr, a recording layer 407 made of TbFeCoCr, and a recording auxiliary layer 408 made of GdFeCoCr are formed on an optical disk substrate 401 via a dielectric layer 402. An intermediate dielectric layer 409 made of ZnS and a heat absorbing layer 412 made of AlTi are further laminated thereon, and an overcoat layer 410 is formed thereon.

With this configuration, in the recording layer of the present embodiment, a signal recorded in the recording layer is transferred for reproduction via the intermediate layer and the control layer, so that recording and reproduction can be performed by a DWDD system using the movement of a magnetic domain wall in the reproduction layer.

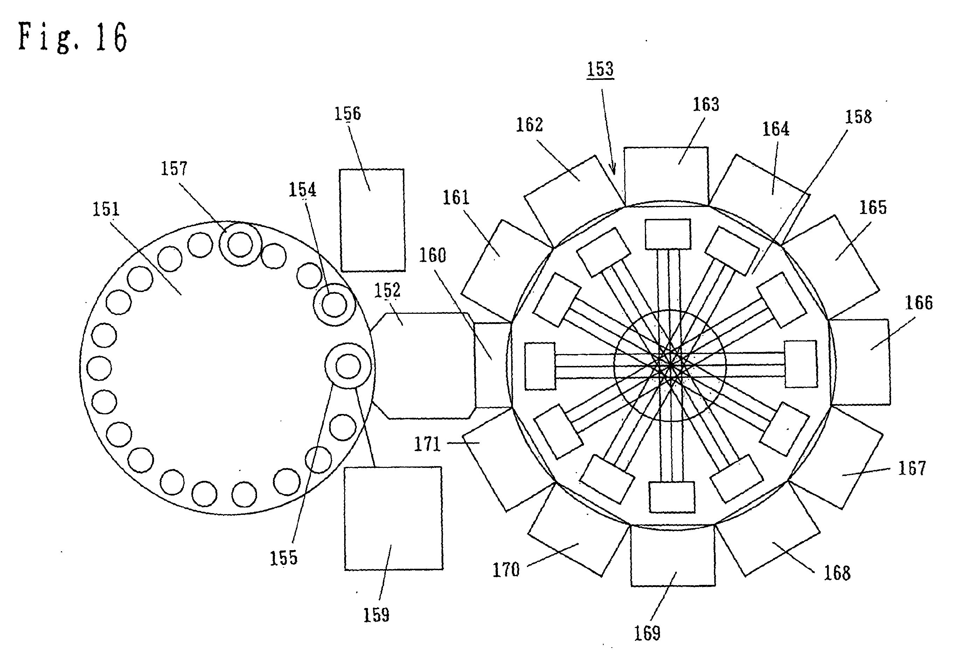

Referring to Figures 16, 17(a), and 17(b), the following will describe a sputtering apparatus of manufacturing an optical recording medium according to Embodiment 6 of the present invention. As shown in Figure 16, as with Embodiment 1, a sputtering film deposition apparatus of manufacturing an optical recording medium of the present invention is constituted of a degassing chamber 151, a sealing chamber 152 for inert gas, and a film deposition sputtering chamber 153.

Here, the degassing chamber 151 of the present embodiment comprises a heating mechanism 157 using an infrared lamp for vacuum degassing in the degassing chamber 151 in addition to a loading chamber 154 and an unloading chamber 155 which feed and carry an optical disk substrate into the degassing chamber 151, so that heating and degassing can be performed on an optical disk substrate in a vacuum.

Moreover, the film deposition sputtering chamber 153 is constituted of a loading/unloading chamber 160, a plurality of vacuum film deposition chambers 161 to 171, and a vacuum carrying chamber 158 of carrying a substrate between the vacuum film deposition chambers.

In this configuration, the unloading chamber of the degassing chamber 151 and the loading/unloading chamber 160 of the film deposition sputtering chamber 153 are connected to each other via the sealing chamber 152 filled with Ar gas as inert gas.

The following will describe a manufacturing process in the sputtering apparatus of manufacturing the optical recording medium according to Embodiment 6 of the present invention.

First, an optical disk substrate having prepits and grooves formed thereon is fed from the loading chamber 154 at a feeding port of the degassing chamber 151, and gas adsorbed on the optical disk substrate is removed while the substrate is moved in the degassing chamber.

A substrate heating mechanism 157 is mounted at some midpoint of the movement in the degassing chamber 151. Irradiation is performed by an infrared lamp at 1 kW for 4 seconds, so that the optical disk substrate is heated in a vacuum and discharge of gas from the substrate is accelerated.

The substrate is moved through the sealing chamber 152 for inert gas from the unloading chamber 155 of the degassing chamber in a short time, and is carried and moved into the film deposition sputtering chamber 153 from the loading/unloading chamber 160 (an example of step (a) of the present invention).

Subsequently, the movement to the vacuum film deposition chamber is performed by moving the optical disk substrate from the loading/unloading chamber 160 to the vacuum film deposition chamber 161 through the evacuated vacuum carrying chamber 158.

At this point, since the optical disk substrate is moved from the loading/unloading chamber after evacuation is performed from atmospheric pressure, a degree of vacuum is low. When the optical disk substrate is moved from the loading/unloading chamber, the vacuum carrying chamber 158 for carrying the optical disk substrate is temporarily reduced in degree of vacuum due to the influence of the loading/unloading chamber.

However, just before the optical disk substrate starts moving from the loading/unloading chamber to the vacuum carrying chamber, the loading/unloading chamber and the carrying chamber have a degree of vacuum permitting an equal pressure through a bypass tube before the substrate starts moving from the vacuum film deposition chamber to the carrying chamber.

As a result, in the present embodiment, the loading/unloading chamber and the vacuum carrying chamber are substantially equal in pressure 1.5 seconds before the optical disk substrate starts moving from the loading/unloading chamber to the carrying chamber.

Consequently, it is possible to reduce a peak pressure when a degree of vacuum temporarily decreases during the movement of the optical disk substrate from the loading/unloading chamber to the carrying chamber, and it is possible to simultaneously perform evacuation using a turbo-molecular pump of the carrying chamber 158. Thus, the optical disk substrate from the vacuum film deposition chamber can be moved and carried into the vacuum carrying chamber while being kept at a higher degree of vacuum.

As a result, the optical disk substrate moves through the vacuum film deposition chambers 161 to 171 whilemoving in the vacuum carrying chamber at a high degree of vacuum, and the optical disk substrate moves through the vacuum film deposition chambers 161 to 171 kept at a higher degree of vacuum (an example of step (d) of the present invention), thereby permitting film deposition (an example of step (c) of the present invention).

The followingwill describe a film deposition process of the film deposition sputtering chamber. Figure 17(a) is the outline of a sectional structural view showing the vacuum film deposition chamber of the sputtering film deposition apparatus of manufacturing the optical recording medium of the present invention. Moreover, Figure 17(b) is a plan view showing the shapes of a shielding plate 611, a target 607, and an optical disk substrate 608 and the positional relationship thereof.

As shown in Figure 17(a), the vacuum film deposition chamber 161 of the sputtering apparatus comprises a sputtering gas introducing port 602 and a vacuum evacuation port 612 for vacuum evacuation using a vacuum pump.

Further, in the vacuum film deposition chamber 161, a sputtering cathode 604 and a substrate holder 606 opposed to the sputtering cathode 604 are placed (an example of step (b) of the present invention). The substrate holder 606 is supported with a carrying mechanism 605 on the back, and is carried into another vacuum film deposition chamber or the air outside the vacuum film deposition chamber by using the carrying mechanism 605.

Moreover, when the substrate holder is carried into another vacuum film deposition chamber, the holder is carried into another vacuum film deposition chamber through the vacuum carrying chamber connected to the vacuum film deposition chamber 161.

The target 607 is mounted on the sputtering cathode 604 made of a magneto-optical recording medium material. Magnets 603 are placed on the back of the target 607 so as to generate a magnetic field on a surface of the target 607.

Moreover, the optical disk substrate 608 for the deposition of the optical recording medium is mounted on the substrate holder 606 opposed to the target.

Additionally, the sputtering cathode 604 is connected to a direct-current power supply 609 outside the vacuum film deposition chamber 161, and the supply of direct-current power to the cathode 604 can be set by a computer for control.

After the recording film is deposited in the vacuum film deposition chamber, the substrate holder 606 uses the carrying mechanism 605 on the back and moves to the other vacuum film deposition chambers in sequence through the vacuum evacuation carrying chamber 158.

Further, after the recording film is deposited on the optical disk substrate, when the optical disk is taken out from the apparatus, the optical disk substrate is moved to the loading/unloading chamber 160 through the vacuum carrying chamber 158, Ar gas is introduced into the loading/unloading chamber 160, and a pressure is set at atmospheric pressure. Thereafter, the optical disk substrate is carried into the sealing chamber, is taken out from the film deposition apparatus, and the film deposition process of the recording film is completed and the substrate is advanced to the subsequent process.

In this process, the vacuum film deposition chambers 161 and 162 of the sputtering apparatus introduce Argon gas and nitrogen gas via the sputtering gas introducing port, and an evacuating speed of the vacuum evacuation pump through the vacuum evacuation port 612 is controlled, so that a pressure in the vacuum film deposition chamber 161 is kept at 0.3 Pa.

In this way, after the inside of the vacuum film deposition chamber 161 is kept at the predetermined pressure, electric power is supplied to the Si target 607 mounted on the sputtering cathode 604 from the connected direct-current power supply 609, DC discharge is generated by the electric power, and a SiN film is formed on the optical disk substrate by reactive sputtering of Si.

Subsequently, in each of the vacuum film deposition chambers 163 to 169, the target 607 for the deposition of the optical recording medium is mounted on the sputtering cathode 604, and the optical disk substrate is subjected to film deposition while moving through the vacuum chambers in sequence through the carrying chamber 158.

In the vacuum film deposition chamber 163, Argon gas is introduced via the sputtering gas introducing port 602, evacuation is performed by the vacuum pump through the vacuum evacuation port 612, and an amount of introduced gas and an evacuating speed are controlled, so that a pressure in the vacuum film deposition chamber 163 is kept at 0.6 Pa.

In this way, after the inside of the vacuum film deposition chamber 163 is kept at the predetermined pressure, electric power is supplied to the recording film target 607 mounted on the sputtering cathode 604 from the connected direct-current power supply 609, and thus DC discharge is generated.

As a result, an optical recording medium thin film made of a target material is deposited on the optical disk substrate via the SiN film. In this process, the optical recording medium thin films are successively deposited on a part other than a mask mounted and held on the substrate holder 606 on the optical disk substrate 608 made of a plastic.

Further, in the vacuum film deposition chamber 170, Argon gas and nitrogen gas are introduced, and the inside of the vacuum film deposition chamber is kept at 0.3 Pa. Thereafter, electric power is supplied to the Si target 607 mounted on the sputtering cathode 604 from the connected direct-current power supply 609, DC discharge is generated by the electric power, and a SiN film is formed on the optical disk substrate by reactive sputtering of Si. Then, in the vacuum film deposition chamber 171, Ar gas is introduced at an Ar pressure of 0.5 Pa and a heat absorbing layer of the AlTi film is deposited with a thickness of 40 nm.

In this way, the optical disk substrate 608 for the deposition of the optical recording medium is mounted and held on the substrate holder 606 so as to be opposed to the targets of the vacuum film deposition chambers 161 to 171. The substrate is moved through the vacuum film deposition chambers in sequence and thus the dielectric layer, the heat absorbing layer, and the recording film are deposited.

Further, in this state, the vacuum film deposition chamber 168 of the recording layer comprises a shielding plate 611 between the optical disk substrate 608 and the target 607 in such a manner that the optical disk substrate is partially shielded. The target material is deposited on the optical disk substrate only from a part of it (Figure 26).

Figure 26 is a diagram showing that the recording film is deposited in a laminated manner with the configuration in which the shieldingplate 611 is provided and the optical disk substrate 401 is rotated on its axis. Here, on the optical disk substrate 608, grooves 431a and 431b and lands 432a and 432b are formed for each recording track.

In this configuration, the substrate holder of holding the optical disk substrate is set at 120 rpm, and thus it is possible to intermittently grow a thin film of the optical recording medium.

In this process, optical recording medium thin films are laminated as fine layers on the plastic substrate 608 mounted and held on the substrate holder 606.

After the process is completed and discharge caused by sputtering is stopped or low discharged power is maintained, the substrate holder 606 is separated by the carrying mechanism from the position opposed to the target, and is carried into another vacuum film deposition chamber through the vacuum carrying chamber connected to the vacuum film deposition chamber 168.

In this configuration, a radius D of the target is set at 55 mm, a radius a of the optical disk substrate is set at 26 mm, and a distance h between the target and the substrate is set at 35.mm, which satisfies the relationship of D < a + h. With the configuration having a large target area and a distance of 30 mm or more between the optical disk substrate and the target, even in the case of high-density recording using the DWDD system, an optical recording medium can be obtained with uniform film characteristics over the optical disk substrate.

Moreover, in accordance with the accompanying drawings, the following will describe a method of manufacturing the recording film using the sputtering method of the magneto-optical recording medium of the present embodiment.

Figure 14(a) schematically shows the movement of sputtering particles during film deposition using the sputtering of the present invention, and Figure 14(b) schematically shows the state of the sputtering particles in an example of a conventional film deposition method.

The example of the conventional manufacturing method in Figure 14(b) shows the configuration where an optical disk substrate moves and passes above an alloy target for a recording film to deposit a recording film while revolving and rotating on its axis. As shown in Figure 14(b), as in the case of the embodiment of the present invention shown in Figure 14(a), when the substrate passes directly above the target, particles sputtered in oblique directions, which are indicated by arrows, are less likely to adhere to the inside of a groove, that is, behind of a land, and is likely to adhere to the center of the groove.

However, when the optical disk substrate moves to a position diagonal to the target, the particles sputtered in the oblique directions are likely to adhere to the inside of the groove, particularly around a boundary between the groove and the land or around a tilted part of the land.

As a result, in the conventional art, a difference in thickness hardly appears between the center of the groove and the boundary between the groove and the land, thereby forming a uniform recording film in the groove.

Meanwhile, in the manufacturing method of Figure 14(a) according to the embodiment of the present invention, an optical disk substrate is opposed directly above an alloy target which has a composition corresponding to the composition of a recording film, and the recording film is formed while the substrate is rotated on its axis or rested.

In this manufacturing method, as indicated by the arrows of Figure 14(a), the sputtered particles change in sputtering angles and distribution depending upon elements. Particles sputtered perpendicularly to a target surface directly above the alloy target are likely to adhere to the substrate, particularly inside of the groove. Particles sputtered in the oblique directions are shielded by the land and thus adhere to the center of the groove. However, since the boundary between the groove and the land is behind the land, the film is less likely to adhere.

In the present embodiment, a distance between the target and substrate is 35 mm. When a distance is increased between the target and the substrate or when the shielding plate 611 is provided between the target and the substrate as shown in Figure 17(a), the above tendency is further developed.

There has been a problem in the method of forming an optical recording medium material by using the film deposition apparatus in which the optical disk substrate is placed on a position opposed to the target. That is, it is possible to stably form films with high productivity, however, when a film is formed directly above the substrate, the film has a large internal stress and small magnetic anisotropy.

However, the present invention provides the method of repeatedly performing film deposition in an area not being masked by the shielding plate on the target surface. The recording layers laminated for each monoatomic unit are formed while the substrate is rotated on its axis, so that the recording layers can be formed in a laminated manner.

Namely, in the embodiment of the present invention, the vacuum film deposition chamber 168 for the recording layers comprises the shielding plate 611 between the optical disk substrate 608 and the target 607 so as to partially shield the optical disk substrate. It is possible to intermittently grow the thin films of the optical recording medium and to form the recording layers in a laminated manner while rotating the substrate holder of holding the optical disk substrate at high speed, so that it is possible to form thin films with excellent magnetic properties for the recording film and achieve sufficient magnetic properties even in the film deposition method having the opposed target.

Further, in the above method, the shielded area of the optical disk substrate opposed to the target is 50 % or larger on the area of the optical disk substrate. Thin films are laminated and formed while rotation is performed at a high speed of 100 rpm or more, thereby forming thin films for the excellent recording film having magnetic properties which permit recording and reproduction with high density.

The configuration of the magneto-optical recording medium manufactured by the manufacturing apparatus of such an optical recording medium has the structural section of the magneto-optical recordingmedium according to Embodiment 6 of the present invention.

Here, the optical recording medium of the present embodiment has the same configuration as that of Figure 11. A recording film is formed on the optical disk substrate 401 via the dielectric layer 402 which is made of SiN with a thickness of 50 nm.

The recording film is constituted of the reproduction layer 403 made of GdFeCoCr with a thickness of 20 nm, the second reproduction layer 404 made of GdFeCr with a thickness of 20 nm, the control layer 405 made of TbFeCoCr with a thickness of 10 nm, the intermediate layer 406 made of TbFeCr with a thickness of 10 nm, the recording layer 407 made of TbFeCoCr with a thickness of 60 nm, and the recording auxiliary layer 408 made of GdFeCoCr with a thickness of 20 nm. The recording film is formed of the six magnetic thin films.

Further, a signal recorded in the recording layer is transferred to the reproduction layer having a two-layer structure via the intermediate layer. Moreover, the dielectric layer 409 made of SiN with a thickness of 30 nm and the heat absorbing layer 412 made of AlTi with a thickness of 40 nm are laminated on the recording film by the sputtering apparatus. The overcoat layer 410 is applied by spin coating and is formed of an ultraviolet curing resin on the AlTi layer.

Here, in the recording film, a recording magnetic domain of the TbFeCo recording layer is magnetically coupled and transferred to the reproduction layer via the intermediate layer during reproduction of a signal, and the reproduction layer in a light spot for reproduction is expanded and reproduced by the movement of the magnetic domain wall because the intermediate layer reaches the Curie temperature as the recording film increases in temperature and because the reproduction layer is small in magnetic domain wall coercive force in a temperature range equal to or higher than the Curie temperature.

Thus, in the recording magnetic layer, reproduction can be performed even in the case of a small recording domain equal to or smaller than the limit of the light spot.

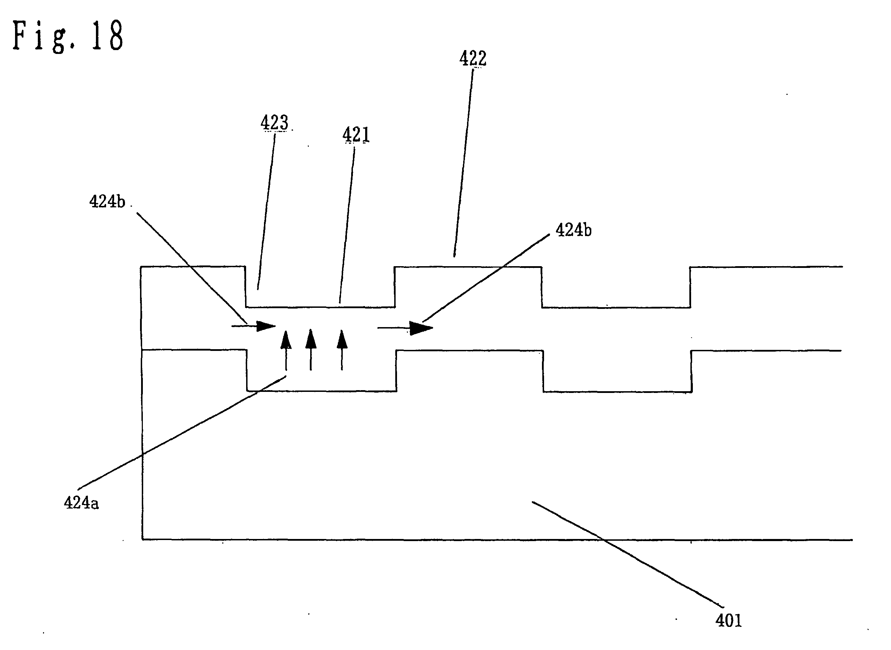

Further, as described in Figure 14(a), in the groove of the optical disk substrate 401, the characteristics such as a film thickness are distributed on the boundary between a land 422 and a center 421 of the groove. In Figure 18, as schematically indicated by the arrows 424a and 424b, the magnetization in the recording layer differs between the center 421 of the groove and a boundary 423 between the groove and the land.

As shown in Figure 18, while a magnetizing direction 424a of the recording film on the center of the groove 421 is perpendicular to the film surface, a magnetizing direction 424b of the recording film is the intra-surface direction on the boundary 423 between the groove and the land. Thus, it is possible to manufacture the recording film which tends to decrease in magnetic anisotropy perpendicular to the film surface of the recording film.

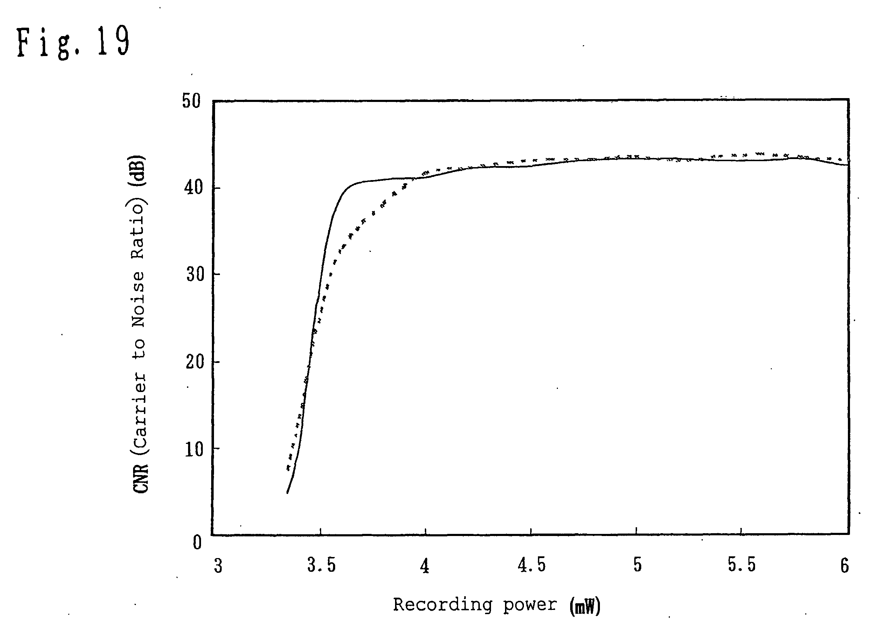

As a result, as indicated by a solid line showing the dependence of a carrier level on recording power in Figure 19 according to the embodiment of the present invention, since the magnetization of the recording film has the perpendicular direction 424a and the intra-surface direction 424b, even when recording power is small, as compared with the recording film of the conventional optical recording medium indicated by a dotted line, it is possible to achieve a recording film with a sharp increase in carrier level.

As a result, even when recording power is small, the recording magnetic domain is more likely to expand in the width direction of the groove, thereby obtaining large reproduction signal amplitude. Even when recording and reproduction are performed with high density according to the DWDD system, it is possible to increase a recording and reproducing power margin.

Further, while the conventional magneto-optical recording medium is relatively large in grain size and has a particle diameter of 20 to 50 nm in each fine structure, the present invention has a particle diameter of 3 nm or smaller in each fine structure and the grains are equal in size.

As a result, in the optical recording medium of Embodiment 6 of the present invention, even when a fine recording domain is transferred to the reproduction layer by the movement of the magnetic domain wall and is reproduced, the film having a moving magnetic domain wall has uniform characteristics. Thus, a signal from the recording layer is transferred and reproduced with stability.

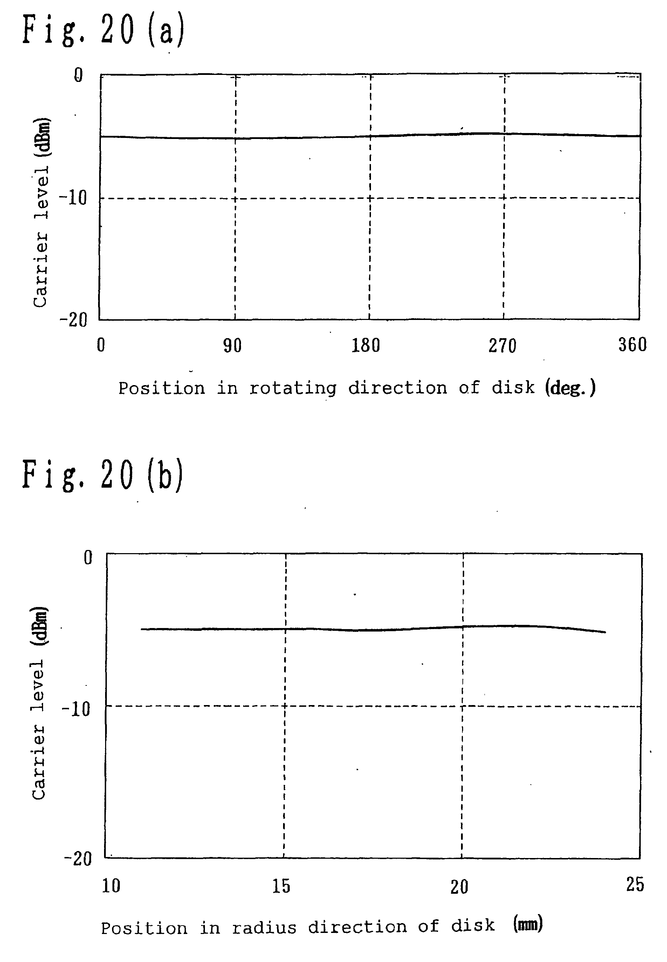

Moreover, as a result, regarding the optical recording medium according to Embodiment 6 of the present invention, Figure 20(a) shows the distribution of carrier levels of the reproduction signal in one round of the disk, and Figure 20(b) shows the distribution of carrier levels in the radius direction of the disk.

At this point, the recording mark length is 0.3 µm. Even in the case of such a small recording domain, it is possible to achieve the following excellent characteristics: a change in signal amplitude is 0.3 dB or smaller in one round of the disk and a change in signal amplitude in the radius direction of the disk is 0.6 dB or smaller.

In this way, with the shielding plate between the target and the substrate, the present invention artificially performs intermittent film deposition. Thus, a fine laminated structure is obtained and thus the magneto-optical recording medium can be achieved with stable characteristics.

### (Embodiment 7)

The following will describe an optical recording medium and a manufacturing method thereof according to Embodiment 7 of the present invention.

The present embodiment has the same configuration as that of the sputtering apparatus of manufacturing the optical recording medium shown in Figure 9 according to Embodiment 4 of the present invention. Namely, as shown in Figure 9, a sputtering apparatus of manufacturing the optical recording medium of the present invention is constituted of a degassing chamber 101, a sealing chamber 102 for inert gas, and a film deposition sputtering chamber 103.

As shown in Figure 9, the degassing chamber is reduced in required space because of its circular vacuum degassing chamber, and a substrate is fed and carried into the degassing chamber 101 by a loading chamber 104 and an unloading chamber 105 for an optical disk substrate. In addition, a heating mechanism 107 using an infrared lamp is provided for vacuum degassing in the degassing chamber 101, thereby performing heating and degassing on an optical disk substrate in a vacuum.

Moreover, the film deposition sputtering chamber 103 is constituted of a loading/unloading chamber 110, a plurality of vacuum film deposition chambers 111 to 123, and a vacuum carrying chamber 130 of carrying the substrate between the vacuum film deposition chambers.

In this configuration, the unloading chamber of the degassing chamber 101 and the loading/unloading chamber 110 of the film deposition sputtering chamber 103 are connected to each other via the sealing chamber 102 filled with nitrogen gas used as inert gas.

Further, the loading chamber 104 of the degassing chamber 101 is connected to a disk supply device 106. The optical disk substrate before film deposition carries a stocked optical disk substrate from the disk supply device 106 to the loading chamber 104 of the degassing chamber 101.

Moreover, the loading/unloading chamber 110 of the film deposition apparatus 103 is connected to a disk stock device 108. The film-deposited magneto-optical recording mediums are carried from the loading/unloading chamber 110 of the film deposition sputtering chamber 103, and then, the mediums are moved to the disk stock device 108 and are stocked after being divided for each disk condition.

Besides, regarding the sputtering apparatus according to the method of manufacturing the optical recording medium of the present embodiment, the manufacturing process is the same as that of Embodiment 4. Thus, the detailed description thereof is omitted.

First, the optical disk substrate having prepits and grooves formed thereon is fed from the loading chamber 104 at a feeding port of the degassing chamber 101 from the disk supply device 106, and gas adsorbed on the optical disk substrate is removed while the substrate is moved in the circular degassing chamber.

Further, the substrate heating mechanism 107 is mounted at some midpoint of the movement in the degassing chamber 101. Irradiation is performed by the infrared lamp at 1.0 kW for 4 seconds, so that the optical disk substrate is heated in a vacuum and discharge of gas from the substrate is accelerated.

The substrate is moved through the sealing chamber 102 for inert gas from the unloading chamber 105 of the degassing chamber in a short time, and is carried and moved into the film deposition sputtering chamber 103 from the loading/unloading chamber 110.

Subsequently, the movement to the vacuum film deposition chamber is performed by moving the optical disk substrate from the loading/unloading chamber 110 to the vacuum film deposition chamber 111 through the evacuated carrying chamber 130.

During the movement of the optical disk substrate, the carrying chamber 130 is further evacuated by a turbo-molecular pump, and then, the optical disk substrate is moved to the vacuum film deposition chambers 111 to 123.

As shown in Figure 4, each of the vacuum film deposition chambers 111 to 113 comprises a sputtering gas introducing port 21, the turbo-molecular pump 22, and a vacuum evacuation port 24 for evacuation using an oil-sealed rotary vacuum pump 33.

Moreover, a sputtering cathode 25 and a substrate holder 26 opposed to the sputtering cathode 25 are placed in the vacuum film deposition chamber. The substrate holder 26 is supported with a carrying mechanism 25 on the back, and is sequentially moved to another vacuum film deposition chamber through the vacuum evacuation carrying chamber 130 by using the carrying mechanism 25.

Further, after nitrogen gas is introduced into the loading/unloading chamber 110 and a pressure is set at atmospheric pressure, the optical disk substrate after film deposition is carried into the sealing chamber, and the film deposition process of the recording film is completed and the substrate is advanced to the subsequent process.

In each of the vacuum film deposition chambers 113 to 121, a target 27 for film deposition of the optical recording medium is mounted on the sputtering cathode 25. Similarly, an Si target for film deposition of the dielectric film is mounted on the sputtering cathode 25 in each of the vacuum film deposition chambers 111, 112, 122, and 123.

Additionally, a shielding plate 31 is placed between the substrate holder 26 and the target 27 mounted on the sputtering cathode 25. When the recording film of the optical recording medium is not deposited on the optical disk substrate 28, shielding is performed between the target 27 and the optical disk substrate 28 as necessary. Only when film deposition is performed on the optical recording medium, the shutter 31 is moved and opened to permit film deposition.

In the operation of the sputtering apparatus configured thus, Argon gas and nitrogen gas are introduced into the vacuum film deposition chamber 111 via the sputtering gas introducing port 21, evacuation is performed through the vacuum evacuation port 24, and an amount of introduced gas and an evacuating speed are controlled, so that a pressure in the vacuum film deposition chamber 111 is kept at 0.4 Pa.

In this way, after the inside of the vacuum film deposition chamber 111 is kept at the predetermined pressure, electric power is supplied to the Si target mounted on the sputtering cathode 24 from the connected direct-current power supply 29, DC discharge is generated by the electric power, and a SiN film is formed on the optical disk substrate by reactive sputtering of Si. Also in the vacuum film deposition chamber 112, a SiN film is deposited under the same conditions in order to shorten the film deposition time of SiN.

The substrate is moved to the subsequent vacuum film deposition chamber 113 through the carrying chamber 130. Then, a pressure in the vacuum film deposition chamber 113 is kept at 0.3 to 5 Pa, and sputtering film deposition is performed by the respective targets.

In this way, after the dielectric film is deposited in the vacuum film deposition chambers 111 and 112, the optical disk substrate 28 for film deposition of the optical recording medium is mounted and held on the substrate holder 26 on a position opposed to the target in each of the vacuum film deposition chambers 113 to 121. The substrate is moved through the vacuum film deposition chambers in sequence and the recording film is deposited.

Moreover, in each of the vacuum film deposition chambers 122 and 123, SiN of the dielectric film is deposited by reactive sputtering.

Additionally, as with Embodiment 4, the following method is also applicable: after the SiN film is deposited in the vacuum film deposition chamber 112, Ar ions are emitted onto the SiN film on the optical disk substrate by the ion gun, and then, the recording films are successively laminated.

Besides, in the above film deposition process, since the optical disk substrate is opposed directly above the target, the substrate holder of holding the optical disk substrate comprises a cooling mechanism using cooling water.

The following will describe the configuration of a magneto-optical recording medium which is manufactured by the manufacturing apparatus of such an optical recording medium.

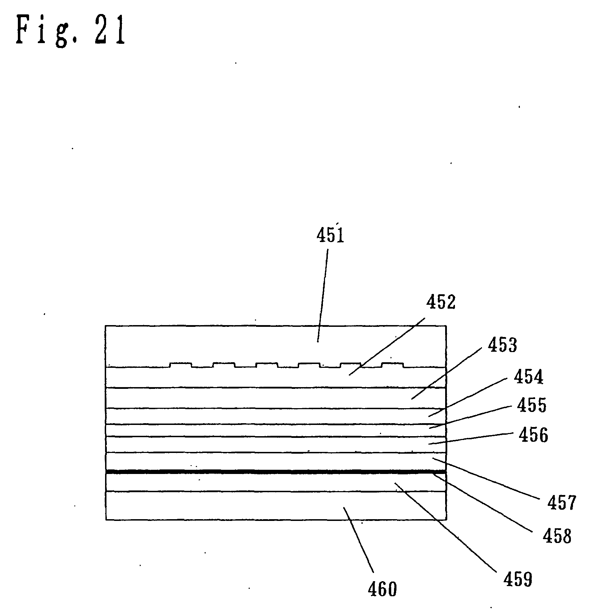

Figure 21 is a sectional view showing the configuration of the magneto-optical recording medium according to the embodiment of the present invention.

As shown in Figure 21, a recording film is formed on an optical disk substrate 451 via a dielectric layer 452 made of SiN.

Here, the recording film is constituted of a reproduction layer 453 made of GdFeCoCr, a control layer 454 made of TbFeCo, an intermediate layer 455 made of TbFe, two recording layers 456 and 457 made of TbFeCoCr, and an interface layer 458 composed of a Co thin film. The recording film is formed of the six magnetic thin films.

Further, a dielectric layer 459 made of SiN is laminated on the recording film, and an overcoat layer 460 is applied and formed by curing thereon.

Here, when a signal is reproduced, in the recording film, a recording magnetic domain of the TbFeCoCr recording layer is magnetically coupled and transferred to the reproduction layer via the intermediate layer, and the reproduction layer in a light spot for reproduction is expanded and reproduced by the movement of the magnetic domain wall because the intermediate layer reaches the Curie temperature as the recording film increases in temperature and because the reproduction layer is small in magnetic domain wall coercive force in a temperature range equal to or higher than the Curie temperature. Thus, in the recording magnetic layer, reproduction can be performed even in the case of a small recording domain equal to or smaller than the limit of the light spot.

In the configuration of the optical recording medium according to the present embodiment, the reproduction layer 453 made of GdFeCoCr, the control layer 454 made of TbFeCo, the intermediate layer 455 made of TbFe, and the two recording layers 456 and 457 made of TbFeCoCr are laminated in sequence via the SiN film having a thickness of 70 nm. During film deposition, targets corresponding to the respective compositions are provided in the separate vacuum film deposition chambers 113 to 121, and the optical disk substrate is placed on positions opposed to the targets and is subjected to film deposition in sequence while being rotated on its axis.

Of the two recording layers 456 and 457 made of TbFeCoCr, the first recording layer 456 is laminated as a 20-nm recording layer composed of 4-nm layers in the vacuum film deposition chambers 117 and 118. Further, the second recording layer 457 is laminated as a 40-nm layer composed of 5-nm layers in the vacuum film deposition chamber 119.

The interface layer 458 composed of a Co thin film is subjected to film deposition of a Co thin film with a thickness of 0.5 nm in an Ar atmosphere of 1.2 Pa in the vacuum film deposition chamber 119, and is exposed to the atmosphere of the apparatus for 15 seconds in total in the vacuum film deposition chambers 120 and 121, so that a Co interface layer is formed.

The other magnetic films of the recording layer are carried and moved in carrying time of 3 seconds, and the recording layers are successively deposited in the film deposition time of 5 seconds, so that each optical recording medium can be manufactured in ten seconds.

Conventionally, in a method of using magnetically induced super-resolution and performing expansion and reproduction using the movement of a magnetic domain wall in the reproduction layer, when a magnetic domain wall is moved with stability in the reproduction layer, in the case where the characteristics of the magnetic film are distributed, a signal quantity becomes uneven during reproduction particularly because of the characteristics of the interface on the recording film laminated in a multilayer structure.

Further, when the vacuum evacuation time is increased to stabilize the interface of the recording magnetic film, it is not possible to shorten the film deposition time for each disk.

Furthermore, when the degassing chamber for degassing and the vacuum film deposition chamber are directly connected to each other, although the time for degassing can be shortened, an unloading mechanism for taking out a disk from the apparatus becomes complicated or it takes long time to take out the disk. In any case, a serious problem has arisen in that the deposition time of the recording film is stably shortened to increase productivity.

In response to the problem, the optical disk substrate is carried and moved to the film deposition sputtering chamber 103 from the degassing chamber 101 of the present invention through the inert gas sealing chamber 102 in a short time and is fed into the apparatus. Hence, it is possible to stabilize the magnetic properties of the magnetic film without the necessity for increasing time for degassing and film deposition.

As a result, the recording film can be manufactured for each optical disk and stable interface characteristics are achieved between the laminated recording magnetic films, thereby realizing an excellent optical recording medium.

Further, in the method of transferring a signal in the recording layer to the reproduction layer and performing expansion and reproduction using the movement of a magnetic domain wall in the reproduction layer, when the magnetic domain wall is stably moved in the reproduction layer, the transfer to the reproduction layer and the movement of the magnetic domain wall become unstable because of the influence of the magnetic properties during film deposition of the recording layer, particularly the influence of magnetic anisotropy perpendicular to the film surface.

Meanwhile, in the optical recording medium according to the embodiment of the present invention, the recording layer is formed in a laminated manner and the interface layer is further provided, so that in the method of transferring a signal in the recording film to the reproduction magnetic film and performing expansion and reproduction using the movement of a magnetic domain wall in the reproduction layer, a reproducing magnetic domain can be formed by the stable movement of the magnetic domain wall, thereby stabilizing a signal quantity during reproduction. In addition, it is possible to shorten film deposition time for each disk and ensure productivity.

Actually, for the magneto-optical recording medium of the present embodiment, when the intermediate layer 455 and the recording layers 456 and 457 are formed, the films were deposited into fine layers by DC sputtering.

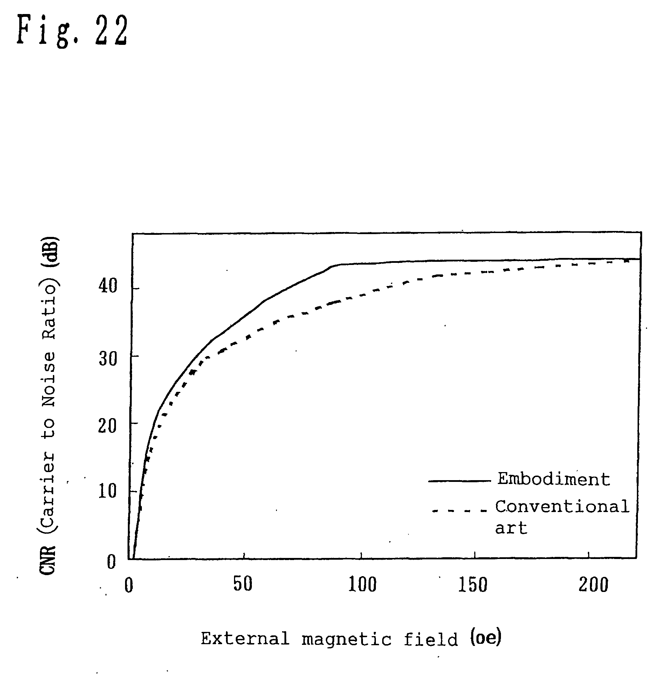

Figure 22 shows the characteristics of a carrier during the reproduction of a signal when the magnitude of a recording magnetic field is changed in the magneto-optical recording medium manufactured thus. When a signal is recorded and reproduced by modulating the intensity of a recording magnetic field while a laser beam is emitted onto the optical recording medium, as indicated by a broken line of Figure 22, the conventional magneto-optical recording medium requires a recording magnetic field of 200 oe or higher. Meanwhile, according to the magneto-optical recording medium of the present invention, even in a recording magnetic field of 110 oe, a carrier level is substantially saturated with a high sensitivity of a recording magnetic field.

It is assumed that because the intermediate layer 455 and the recording layers 456 and 457 formed by the manufacturing method of the present embodiment are laminated with periodicity in a fine structure and the recording interface layer 458 is formed, pinning is thus less likely to occur on a magnetic domain wall (the pinning being caused by an uneven magnetic domain structure of the recording film), a stable recording domain is formed owing to facilely forming of fine domain formation even in a small recording magnetic domain during the recording of a signal, and thus transfer can be stably performed to the reproduction layer 453.

As to the magneto-optical recording medium manufactured thus, in the case where a signal is recorded by modulating the intensity of a magnetic field while a constant laser beam is emitted, when the characteristics of a recording and reproducing signal and the characteristics of a bit error rate are examined, the following results were obtained: the magneto-optical recording medium according to the embodiment of the present invention can have a CNR of 43.5 dB and a bit error rate of 8 × 10⁻⁵ or smaller even in the case of a recording magnetic field of 150 oe or smaller, and quite excellent characteristics are obtained for the recording magnetic field.

As described above, in the magneto-optical recording medium and the manufacturing method thereof according to the present invention, the optical disk substrate is carried into the vacuum film deposition chamber through the degassing chamber and the inert gas sealing chamber, the laminated recording film is deposited by magnetron sputtering, and the magneto-optical recording medium can be achieved with reduced film deposition tact and good signal quality.

In this case, the film deposition time is set at 5 seconds, the carrying time is set at 3 seconds, the film deposition waiting time is set at 1 second, and the standby time of the interface layer is set at 15 seconds in the two vacuum chambers. Since the configuration delivers 20 optical disk substrates to the degassing chamber and moves the substrates to the vacuum film deposition chamber, the degassing chamber standby time is set at 200 seconds for each disk. With this configuration, when the standby time is set at 200 seconds or more, the same or greater effect can be obtained, thereby achieving an optical recording medium with uniform film characteristics.

Additionally, the Co interface layer of the present embodiment may be made of Fe, Al, and Si. A method of etching a surface of the interface layer of the Co thin film with Ar ions by using an ion gun is also applicable.

Moreover, the above embodiment describes the case where the target 27 opposed to the optical disk substrate 28 is one. Even when a plurality of targets having the same composition or having different materials or compositions are opposed to the optical disk substrate, the same effect can be obtained in the method of manufacturing the optical recording medium as long as at least the degassing chamber and the film deposition sputtering chamber are connected to each other via the sealing chamber filled with inert gas and the ion gun is placed in the vacuum film deposition chamber.

### (Embodiment 8)

The following will describe an optical recording medium and a manufacturing method thereof according to Embodiment 8 of the present invention.

The present embodiment is similar in configuration to the sputtering apparatus of manufacturing the optical recording medium shown in Figure 9 according to Embodiment 4 of the present invention. Namely, as shown in Figure 9, a sputtering apparatus of manufacturing the optical recording medium of the present invention is constituted of a degassing chamber 101, a sealing chamber 102 for inert gas, and a film deposition sputtering chamber 103.

As shown in Figure 9, the degassing chamber is reduced in required space because of its circular vacuum degassing chamber, and a substrate is fed and carried into the degassing chamber 101 by a loading chamber 104 and an unloading chamber 105 for an optical disk substrate. In addition, a heating mechanism 107 using an infrared lamp is provided for vacuum degassing in the degassing chamber 1, thereby performing heating and degassing on an optical disk substrate in a vacuum.

Moreover, the film deposition sputtering chamber 103 is constituted of a loading/unloading chamber 110, thirteen vacuum film deposition chambers 111 to 123, and a vacuum carrying chamber 130 of carrying a substrate between the vacuum film deposition chambers.

In this configuration, the unloading chamber of the degassing chamber 101 and the loading/unloading chamber 110 of the film deposition sputtering chamber 103 are connected to each other via the sealing chamber 102 filled with inert gas.

Further, the loading chamber 104 of the degassing chamber 101 is connected to a disk supply device 106. The optical disk substrate before film deposition carries a stocked optical disk substrate from the disk supply device 106 to the loading chamber 104 of the degassing chamber 101.

Moreover, the loading/unloading chamber 110 of the film deposition sputtering chamber 103 is connected to a disk stock device 108. The film-deposited magneto-optical recording mediums are carried from the loading/unloading chamber 110 of the film deposition sputtering chamber 103, and then, the mediums are moved to the disk stock device 108 and are stocked after being divided for each disk condition.

Besides, the manufacturing process using the sputtering apparatus in the method of manufacturing the optical recording medium of the present embodiment is similarly performed. Thus, a detailed description thereof is omitted.

First, the optical disk substrate having prepits and grooves formed thereon is fed from the loading chamber 104 at a feeding port of the degassing chamber 101 from the disk supply device 106, and gas adsorbed on the optical disk substrate is removed while the substrate is moved in the circular degassing chamber.

Further, the substrate heating mechanism 107 is mounted at some midpoint of the movement in the degassing chamber 101. Irradiation is performed by the infrared lamp at 1.2 kW for 4 seconds, so that the optical disk substrate is heated in a vacuum and discharge of gas from the substrate is accelerated. The substrate is moved through the sealing chamber 102 for inert gas from the unloading chamber 105 of the degassing chamber in a short time, and is carried and moved into the film deposition sputtering chamber 103 from the loading/unloading chamber 110.

Subsequently, the movement to the vacuum film deposition chamber is performed by moving the optical disk substrate from the loading/unloading chamber 110 to the vacuum film deposition chamber 111 through the evacuated vacuum carrying chamber 130. During the movement of the optical disk substrate, the vacuum carrying chamber 130 is further evacuated by a turbo-molecular pump, and then, the optical disk substrate is moved to the vacuum film deposition chambers 111 to 123.

In each of the vacuum film deposition chambers 114 to 121, a target for the recording film is mounted on the sputtering cathode to perform deposition of the optical recording medium. Further, a Si target for the deposition of the dielectric film is similarly mounted on the sputtering cathode in each of the vacuum film deposition chambers 111, 112, and 122.

First, as with the configuration of Figure 4, each of the vacuum film deposition chambers 111 and 112 comprises a sputtering gas introducing port 21, a turbo-molecular pump 22, and a vacuum evacuation port 24 of performing evacuation using an oil-sealed rotary vacuum pump 33.

Moreover, a sputtering cathode 25, the Si target, and a substrate holder 26 opposed to the sputtering cathode 25 are placed in the vacuum film deposition chamber. The substrate holder 26 is supported with a carrying mechanism 32 on the back, and is moved to the other vacuum film deposition chambers in sequence through the vacuum evacuation carrying chamber 130 by using the carrying mechanism 32.

Next, in the vacuum film deposition chamber 113, the configuration having a multi-source ion gun 135 like Figure 7 generates and accelerates Ar ions, and the Ar ions are emitted onto the SiN film of the optical disk substrate.

Further, as shown in Figure 17, in each of the vacuum film deposition chambers 114 to 121 of depositing the recording film, a shielding plate 611 is placed between a substrate holder 606 and a target 607 mounted on a sputtering cathode 604, a region between the target 607 and the optical disk substrate 608 is partially shielded as necessary, and the optical recording medium is deposited from a region not being shielded on the optical disk substrate.

Furthermore, in the vacuum film deposition chambers 122 and 123, with the configuration having the sputtering cathode 25, the target 27, and the substrate holder 26 opposed to the sputtering cathode 25 in the vacuum film deposition chamber, movement is performed by the carrying mechanism 32 through the vacuum film deposition chambers in sequence. Here, the Si target is provided in the vacuum film deposition chamber 122, and an AlCr target is provided in the vacuum film deposition chamber 123.

Further, after nitrogen gas is introduced into the loading/unloading chamber 110 and a pressure is set at atmospheric pressure, the optical disk substrate is carried into the sealing chamber, and the film deposition process of the recording film is completed and the substrate is advanced to the subsequent process.

In the operation of the sputtering apparatus configured thus, Argon gas and nitrogen gas are firstly introduced into the vacuum film deposition chamber 111 via the sputtering gas introducing port 21, evacuation is performed through the vacuum evacuation port 24, and an amount of introduced gas and an evacuating speed are controlled, so that a pressure in the vacuum film deposition chamber 111 is kept at 0.4 Pa.

In this way, after the inside of the vacuum film deposition chamber 111 is kept at the predetermined pressure, electric power is supplied to the Si target 27 mounted on the sputtering cathode 25 from a connected direct-current power supply 29, DC discharge is generated by the electric power, and a SiN film is formed on the optical disk substrate by reactive sputtering of Si. Also in the vacuum film deposition chamber 112, a SiN film is deposited under the same conditions in order to shorten the film deposition time of SiN.

Movement is performed to the subsequent vacuum film deposition chamber 113 through the carrying chamber 130. In the vacuum film deposition chamber 113, a pressure of Ar is kept at 0.1 Pa, and Ar ions are emitted by the ion gun 135 onto a surface of the SiN dielectric film on the optical disk substrate.

Moreover, pressures in the vacuum film deposition chambers 114 to 121 are successively kept at 0.5 to 5 Pa, and sputtering film deposition is performed by the respective targets.

At this point, a recording layer 407 is deposited in a laminatedmanner using the four vacuum film deposition chambers 117 to 120, and a target having the same composition as TbFeCoCr is provided in each of the vacuum chambers. As a result, the 80-nm recording layer is formed of four 20-nm layers in a laminated manner.

Additionally, in the vacuum film deposition chamber 122, the same conditions as those of the vacuum film deposition chamber 111 are set and SiN of the dielectric film is deposited by reactive sputtering.

Then, in the vacuum film deposition chamber 123, a pressure is kept at 0.3 Pa and an AlCr thin film of a heat absorbing layer is deposited by sputtering from the AlCr target.

Besides, in the above film deposition process, since the optical disk substrate is opposed directly above the target, the substrate holder of holding the optical disk substrate comprises a cooling mechanism using cooling water.

The following will describe the configuration of a magneto-optical recording medium which is manufactured by using the manufacturing apparatus of such an optical recording medium.

The magneto-optical recording medium according to the embodiment of the present invention has the same structural section as that of Figure 11.

As shown in Figure 11, the recording film is formed on an optical disk substrate 401 via a dielectric layer 402 made of SiN.

In this configuration, the recording film is constituted of the reproduction layer 403 made of GdFeCoCr with a thickness of 40 nm, a second reproduction layer 404 made of GdFeCoCr with a thickness of 25 nm, a control layer 405 made of AlTi with a thickness of 15 nm, an intermediate layer 406 made of SiN with a thickness of 20 nm, a recording layer 407 made of TbFeCoCr with a thickness of 70 nm, and a recording auxiliary layer 408 made of GdFeCoCr with a thickness of 30 nm. The recording film is formed of the six thin films. Additionally, a dielectric layer 409 made of SiN with a thickness of 20 nm and a heat absorbing layer 412 made AlCr with a thickness of 50 nm are laminated in sequence on the recording film, and an overcoat layer 410 and a sliding coat layer 411 are formed on the AlCr layer.

The recording film configured thus is a recording film formed by a MAMMOS system, which performs expansion and reproduction of a magnetic domain by using a method of applying an alternatingmagnetic field from the outside during the reproduction of a signal.

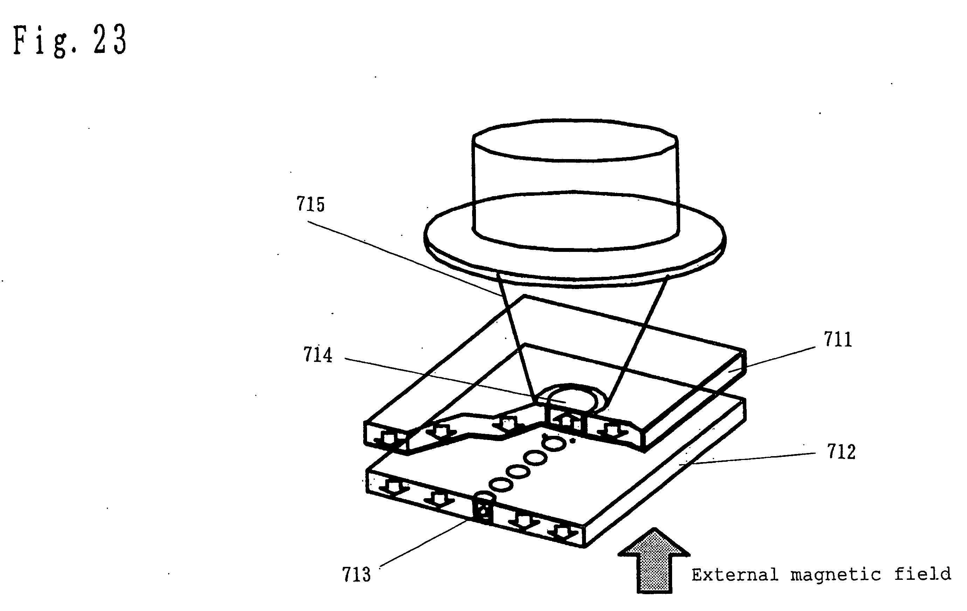

Referring to Figure 23, the reproducing principle of the MAMMOS system will be described below. As shown in Figure 23, in a light spot 715, a recording magnetic domain 713 of a TbFeCo recording layer 712 increases in accordance with the rising of the temperature, and is magnetically coupled and transferred to a reproduction layer 711 via a non-magnetic intermediate layer.

At this point, when an alternating magnetic field is applied from the outside, in the reproduction layer in the light spot for reproduction, a transferred magnetic domain is formed as an expanded magnetic domain 714 due to the direction of the alternating magnetic field from the outside, and the magnetic domain is detected as a reproduction signal.

Hence, in the recording layer 712, even in the case of the small recording magnetic domain 713 equal to or smaller than the limit of the light spot 715, the magnetic domain can be reproduced as the transferred and expanded reproduction magnetic domain 714.

The optical recording medium according to the embodiment of the present invention, in which the MAMMOS system capable of high-density recording and reproduction is used, is constituted of the reproduction layer 403 made of GdFeCoCr, the second reproduction layer 404 made of GdFeCoCr, the control layer 405 made of AlTi, the intermediate layer 406 made of SiN, the recording layer 407 made of TbFeCoCr, and the recording auxiliary layer 408 made of GdFeCoCr on the optical disk substrate via the SiN film. The recording films composed of the six thin films are laminated in sequence. During film deposition, targets corresponding to the respective compositions are provided in separate vacuum film deposition chambers 114 to 121, and the optical disk substrate is placed on positions opposed to the targets and is successively subjected to film deposition while being rotated on its axis.

At this point, the thin films of the optical recording medium that are formed in the respective vacuum film deposition chambers are carried and moved in carrying time of 3 seconds, and a sputtering film deposition velocity is adjusted and set so as to successively deposit and form the films in deposition time of 5 seconds, so that each optical recording medium can be manufactured in 10 seconds.

There has been a problem particularly in a method such as the MAMMOS system of performing expansion and reproduction of a magnetic domain by using magnetically induced super-resolution responding to a higher density. That is, when transfer and expansion are performed with stability in the reproduction layer, in the case where the characteristics of a magnetic film are distributed, particularly in the case where characteristics are distributed in a laminated state of a multilayer structure, a signal quantity becomes uneven during reproduction.

Further, in order to form a fine recording domain, a recording magnetic domain needs to increase in magnetic anisotropy in the perpendicular direction to a film surface. A serious problem arises in that the film deposition time of the recording films is more stably shortened for the optical recording medium with higher productivity.

In response to the problem, the optical disk substrate is carried and moved into the film deposition sputtering chamber 103 from the degassing chamber 101 of the present invention through the inert gas sealing chamber 102 and is fed into the apparatus.

At this point, in the vacuum film deposition chamber 113, surface treatment is performed on the SiN film on the optical disk substrate, so that it is possible to reduce unevenness resulted from degassing from the substrate and a change in surface property before deposition of the magnetic film.

Further, particularly the recording magnetic layer is configured in a laminated manner through the plurality of vacuum film deposition chambers, so that it is possible to improve and stabilize magnetic properties, particularly perpendicular magnetic anisotropy.

As a result, it is possible to achieve an excellent optical recording medium in which stability is secured between the laminated recordingmagnetic films and a small magnetic domain for high-density recording can be formed.

Furthermore, ion etching is performed after the dielectric layer of SiN is deposited on the optical disk substrate, so that the states before the deposition of the recording films can be uniform, a signal in the recording film is transferred to the reproduction magnetic film, and a reproduction magnetic domain can be formed which permits stable expansion of a magnetic domain in the reproduction layer and permits reproduction. Hence, it is possible to stabilize a signal quantity during reproduction. Further, it is possible to shorten film deposition time for each disk and ensure productivity.

Actually, in the case where a signal is recorded in the magneto-optical recording medium manufactured thus by modulating the intensity of a magnetic field while a constant laser beam is emitted, the characteristics of a recording and reproducing signal and a bit error rate were examined and the following results were obtained: the magneto-optical recording medium according to the embodiment of the present invention can have a CNR of 43.2 dB and a bit error rate of 7 × 10⁻⁵ or smaller even in the case of a recording mark with a mark length of 0.16 µm and a recording magnetic field of 180 oe or smaller, and characteristics for the recording magnetic field proved to be excellent.

As described above, in the magneto-optical recording medium and the manufacturing method thereof according to the present invention, the optical disk substrate is carried into the film deposition sputtering chamber through the degassing chamber and the inert gas sealing chamber, film deposition is performed at least on the recording layer by magnetron sputtering in the plurality of vacuum film deposition chambers, so that a magneto-optical recording medium can be achieved with reduced film deposition tact and excellent signal quality.

In this case, the film deposition time is set at 5 seconds or less, the carrying time is set at 3 seconds, the etching time is set at 6 seconds or less, and the film deposition waiting time is set at 1 second. Since the configuration delivers 30 optical disk substrates to the degassing chamber and moves the substrates to the vacuum film deposition chambers, the degassing chamber standby time is set at 300 seconds for each disk. With this configuration, when the standby time is set at 200 seconds or more, the same or greater effect can be obtained, thereby achieving an optical recording medium with uniform film characteristics.

The present embodiment performs film deposition using the four vacuum film deposition chambers during the deposition of the recording layer. The same effect can be obtained as long as deposition is performed using a plurality of vacuum film deposition chambers.

Furthermore, as with Embodiment 5, the same or greater effect can be obtained when a manufacturing method is combined with any one of a method of performing deposition in a laminated manner in respective vacuum chambers by repeating discharge and a method of performing deposition in a laminated structure while rotating an optical disk substrate at high speed in a vacuum chamber using a shielding plate.

Moreover, the present embodiment performs the film deposition method of using the targets with the same composition for the recording layer in the plurality of vacuum film deposition chambers. Even with the configuration where targets for film deposition are slightly shifted in composition in the vacuum chambers of a plurality of vacuum film deposition chambers, the same effect can be obtained by adjusting the target compositions to magnetic properties required in a laminated state.

Further, in the present embodiment, relative to a radius D of the optical disk substrate, when a target size has a radius a of 150 mm or smaller or at least one side of 200 mm or smaller on a rectangle, a distance h between the target and the optical disk substrate is set at 30 to 120 mm, and moreover, when *a* > 2 x D or *a* < D + h are satisfied, it is possible to achieve the same effect as the manufacturing method of the present embodiment. Namely, a bit error rate can be 1 × 10⁻⁴ or smaller.

The following will specifically describe the influence of the relationship among the radius *a* of the target, the radius D of the optical disk substrate, and the distance h between the target and the substrate on jitter in accordance with the accompanying drawings.

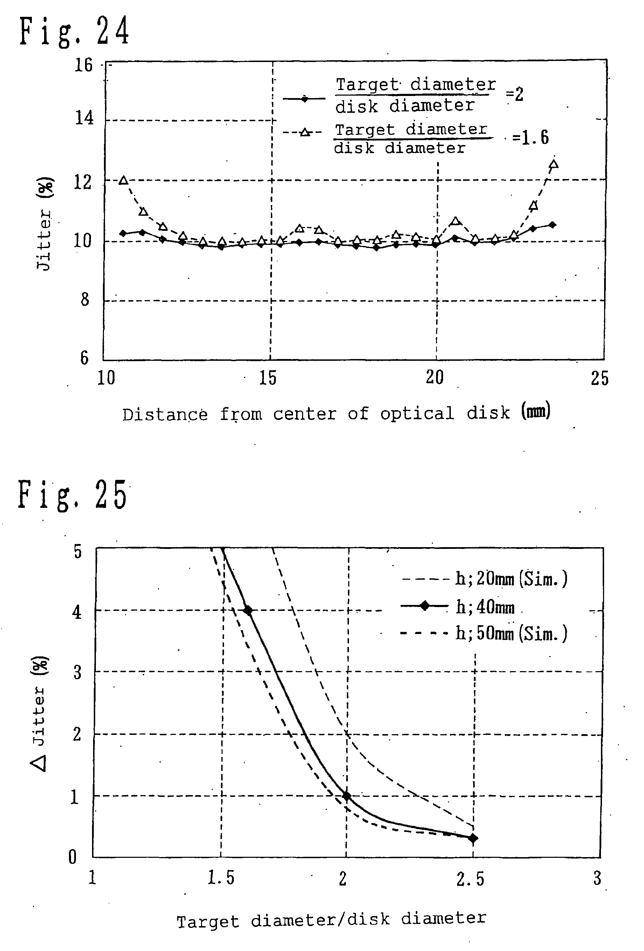

A high-density optical recording medium with a small diameter tends to increase in jitter when the characteristics of the recording film are changed on the inner periphery and the outer periphery of the optical disk. As shown in Figure 24, particularly when a target radius a is set within a range permitting the relationship of *a*/D ≤ 2, jitter is more apt to increase and exceeds a permissible value of jitter. In Figure 24, the horizontal axis indicates a distance (mm) from the center of an optical disk and the vertical axis indicates jitter (%). Figure 24 is a diagram showing changes in jitter relative to distances from the center of the optical disk in the case where a value of *a*/D is 1.6 and 2.0.

Moreover, as shown in Figure 25, even when a distance h between the target and the optical disk substrate is reduced, jitter is more apt to increase on the inner periphery and the outer periphery. Figure 25 is a diagram showing the relationship between jitter and a ratio of a target radius a and a disk radius D in the case of different distances h.

Therefore, it is preferable that the configuration of the apparatus satisfies the relationships of target radius a/disk radius D > 2.0 and distance h > 30 mm. In this case, when a distance h is too large, film deposition efficiency is low and thus productivity is reduced. Therefore, in the case of a disk radius of D = 25 to 30 mm, it is preferable to set a target radius at *a* = 60 mm and a distance h = 40 to 50 mm, thereby achieving a small-diameter disk with uniform film characteristics and excellent signal characteristics.

As described above, the embodiment of the present invention discussed the configuration in which magnetic anisotropy on a boundary of a land in a groove is small in the perpendicular direction to a film surface. The configuration of an optical recording medium and a manufacturing method thereof are acceptable as long as the distribution of perpendicular magnetic anisotropy is provided in the width direction of the groove on the recording layer while the recording film is laminated.

Additionally, also when a light spot for recording and reproduction is emitted in the configuration of the present embodiment, it is possible to reduce cross erasion and crosstalk between a recording track and an adjacent track due to the distribution of magnetic anisotropy. Thus, it is possible to form a temperature distribution suitable for forming a recording magnetic domain in a recording track, particularly in a groove. For this reason, it is possible to stably form a recording magnetic domain with a relatively wide range of recording power, thereby achieving a magneto-optical recording medium having excellent signal characteristics even in high-density recording.

Further, the above embodiment described the method of reproducing the magneto-optical recording medium using the DWDD system or the MAMMOS system. Even when other materials for high-density recording are used as a material of the recording film, the same effect can be obtained as long as an amorphous recording film is manufactured by a sputtering method.

Moreover, the present embodiment described the configuration in which the reproduction layer, the intermediate layer, and the recording layer are laminated on the substrate. The layers may be laminated in the reverse direction. In other words, the same effect can be obtained by using a method of successively laminating the recording layer, the intermediate layer, and the reproduction layer on the substrate and performing reproduction using a laser beam spot or a magnetic head such as a GMR head from the side of the film surface.

Besides, the above embodiment described that the target 27 opposed to the optical disk substrate 28 is one. Even when a plurality of targets having the same composition or having different materials or compositions are opposed to the optical disk substrate, the same effect can be obtained as long as a manufacturing method is compliant with sputtering of an optical disk substrate placed on a position opposed to a cathode, on which at least any one of targets is fixed, and laminating layers periodically.

Further, the present embodiment described etching performed only on the optical disk substrate or etching performed only on a surface of the SiN film. Any method is acceptable as long as ion irradiating conditions are adjusted by combining both kinds of etching, combining the method with etching on the recording magnetic film, or placing the ion gun in the vacuum film deposition chamber.

Furthermore, the above embodiment described that target 27 is opposed to one optical disk substrate 28. Even when targets having different materials and compositions are opposed to a plurality of optical disk substrates, the same effect can be obtained by a method of manufacturing an optical recording medium as long as at least the degassing chamber and the vacuum film deposition chamber are connected to each other via the sealing chamber filled with inert gas and a manufacturing method of an optical recording medium has an ion gun in a vacuum film deposition chamber.

As described above, in the optical recording medium and the manufacturing method thereof according to the present invention, targets having the same composition or having different materials or compositions are opposed to the optical disk substrate, and film deposition is performed while the optical disk substrate is revolved or rotated on its axis. At least the degassing chamber and the vacuum film deposition chamber are connected to each other via the sealing chamber filled with inert gas, and the target radius D and a substrate radius a are set at the predetermined relationship. Additionally, the ion gun is placed in the vacuum film deposition chamber or the film deposition method uses a reversed method. Even in such a configuration, since the recording film is deposited in a laminated manner, it is possible to achieve an optical recording medium and a manufacturing method thereof with high quality and excellent productivity.

Another invention of the inventor will be described below.

First, another first invention is a method of manufacturing an optical recordingmedium, characterized in that a target composed of an optical recording medium and an optical disk substrate on a position opposed to the target are placed in a vacuum chamber, in a sputtering apparatus of manufacturing an optical recording medium by performing magnetron sputtering on the target by using a direct-current power supply on the optical disk substrate having been fixed or rotated on its axis, a gas sealing chamber is provided in contact with a loading/unloading chamber of feeding and taking out the optical disk substrate to and from the sputtering apparatus, the sealing chamber being a region of sealing inert gas to move the optical disk.

Further, another second invention is the method of manufacturing the optical recording medium according to another first invention, characterized in that a degassing chamber of holding the optical disk substrate in a vacuum atmosphere is further provided in contact with the inert gas sealing chamber and the loading/unloading chamber.

With the above configuration, even in the case of a manufacturing method using the sputtering apparatus of a stationary facing type or rotationally facing type, or even when supplied power during sputtering film deposition is increased to perform film deposition at a high film deposition velocity, (1) tact time for each optical disk substrate is shortened for vacuum evacuation, and (2) a film deposition velocity is increased by shortening carrying time with a simple configuration, so that the productivity of the optical recording medium can be improved.

Moreover, another third invention is an apparatus of manufacturing an optical recording medium, characterized in that an optical disk substrate passes while being held in a vacuum in a degassing chamber, the substrate is carried into a vacuum chamber thereafter, a target composed of an optical recording medium and the optical disk substrate opposed to the target are placed in a vacuum chamber, in a sputtering apparatus of manufacturing an optical recording medium by performing magnetron sputtering on the target by using a direct-current power supply on the optical disk substrate having been fixed or rotated on its axis, a gas sealing chamber, which is a region of sealing inert gas to move the optical disk, is provided in contact with a loading/unloading chamber of feeding and taking out the optical disk substrate to and from the sputtering apparatus and with a degassing chamber of holding the disk substrate in a vacuum when the substrate is fed.

With this configuration, even when the tact time during deposition of a recording film is accelerated, it is possible to stably form a recording film having a multilayer structure of the optical recording medium, achieve an optical recording medium with high quality, and achieve a recording film with uniform characteristics in a disk.

Further, another fourth invention is the apparatus of manufacturing the optical recording medium of another third invention, characterized in that nitrogen gas or Ar gas is introduced into the inert gas sealing chamber.

Moreover, another fifth invention is the apparatus of manufacturing the optical recording medium, characterized in that a pressure of air sealed into the inert gas sealing chamber is between 0.2 and 1.5 kg/cm², inclusive.

Besides, another sixth invention is the apparatus of manufacturing the optical recording medium of another third invention, characterized in that a target composed of an optical recording medium and an optical disk substrate on a position opposed to the target are placed in a vacuum chamber, in a sputtering apparatus of manufacturing a plurality of recording films in a plurality of film deposition chambers by performing magnetron sputtering on the target by using a direct-current power supply on the optical disk substrate havingbeen fixed or rotated on its axis, a carrying chamber is further provided to perform movement between the plurality of film deposition chambers, and the timing of starting movement for feeding the optical disk substrate from the loading/unloading chamber to the carrying chamber is different from the timing of starting moving the substrate to the carrying chamber from the film deposition chamber of performing the sputtering.

Further, another seventh invention is the apparatus of manufacturing the optical recording medium of another third invention, characterized in that a target composed of an optical recording medium and an optical disk substrate on a position opposed to the target are placed in a vacuum chamber, in a sputtering apparatus of manufacturing a plurality of recording films in a plurality of film deposition chambers by performing magnetron sputtering on the target by using a direct-current power supply on the optical disk substrate having been fixed or rotated on its axis, a carrying chamber is further provided to perform movement between the plurality of film deposition chambers, after the optical disk substrate is fed into the loading/unloading chamber, the loading/unloading chamber and the carrying chamber become equal in atmospheric pressure, and then, the movement of the optical disk substrate is started from the film deposition chamber of performing sputtering film deposition.

Moreover, another eighth invention is the apparatus of manufacturing the optical recording medium of another third invention, characterized in that the degassing chamber comprises a substrate heating mechanism.

Besides, another ninth invention is the apparatus of manufacturing the optical recording medium of another third invention, characterized in that at least one of the film deposition chambers comprise an ion gun and surface treatment is performed before the recording film of the optical disk substrate is deposited.

Further, another tenth invention is the apparatus of manufacturing the optical recording medium of another ninth invention, characterized in that after deposition of the dielectric layer, ion irradiation is performed by using the ion gun placed in the film deposition chamber.

Additionally, another eleventh invention is the apparatus of manufacturing the optical recording medium of another ninth invention, characterized in that after deposition of the recording layer, ion irradiation is performedby using the ion gun placed in the film deposition chamber.

With this configuration, in the sputtering apparatus of a stationary facing type or rotationally facing type, even when supplied power of sputtering is increased to perform film deposition using high-power sputtering, tact time for each optical disk substrate is shortened for vacuum evacuation, a film deposition velocity is increased by shortening carrying time with a simple configuration, and an optical recording medium can be manufactured with stable characteristics on a recording film.

Moreover, another twelfth invention is an optical recording medium characterized in that after an arranged region of sealing inert gas is moved on the optical disk substrate while the substrate makes contact with a loading/unloading chamber, the optical disk substrate is fed into a vacuum chamber through the loading/unloading chamber, a target made of an optical recording medium and the optical disk substrate opposed to the target are placed in the vacuum chamber, and the target is subjected to magnetron sputtering on the optical disk substrate having been fixed or rotated on its axis, so that the optical recording medium is manufactured by successively laminating multilayer films of the optical recording medium.

Further, another thirteenth invention is an optical recording medium of performing recording or reproducing information by using a light spot, characterized in that a recording layer of the optical recording medium has a fine layered structure in the depth direction.

Also, another fourteenth invention is the optical recording medium of another thirteenth invention, characterized in that periodicity for each fine structure of 10 nm or less is provided in the depth direction of a thin film of the recording layer.

Additionally, another fifteenth invention is the opticalrecording medium of another thirteenth invention, characterized in that each cluster of a fine magnetic domain in the depth direction of the thin film in the recording layer has periodicity of each fine structure of 10 nm or less.

Besides, another sixteenth invention is the optical recording medium of another thirteenth invention, characterized in that at least one of the thin films laminated in the recording layer is an extremely thin layer of 1 nm or less.

Also, another seventeenth invention is the optical recording medium of another thirteenth invention, characterized in that the optical disk substrate has grooves thereon, and the recording layer of the optical recording medium that is formed on the optical disk substrate is changed in magnetic anisotropy at least in the intra-surface direction of the grooves.

With this configuration, the recording layer can form a sufficiently wide recordingmagnetic domain in the width direction of the groove and it is possible to stably perform transfer of the recording magnetic domain to the reproduction layer.

As described above, with the method of manufacturing the optical recording medium and the manufacturing apparatus of the invention described in the present specification, it is possible to form a thin film of an optical recording medium having a fine grain structure in a laminated manner with high productivity.

Hence, because of improvement in perpendicular magnetic anisotropy, it is possible to achieve a magneto-optical recording medium which can stably form a magnetic domain and a structure which has excellent characteristics of a recording magnetic field or stably reproduces a signal while a magnetic domain is expanded using the movement of a magnetic domain wall and so on.

Further, in the case of a thin film of an amorphous optical recording medium, it is possible to provide a manufacturing method of an optical recording medium with which the stress on the thin film of the recording film can be reduced and films are evenly formed.

### Industrial Applicability

As is evident from the above description, the present invention offers an advantage in that a recording film can be more uniform as compared with the conventional art.

## Claims

1. A film deposition method for an optical disk, comprising:
a step (a) of carrying an optical disk substrate into a vacuum chamber,
a step (b) of placing the optical disk substrate opposed to a target containing a film forming material, the target being provided in the vacuum chamber, and
a step (c) of forming a predetermined film on the optical disk substrate by a sputtering method using the target, the optical disk substrate being fixed, rotated on an axis, or revolved,
wherein when the target has a radius of a and the optical disk substrate has a radius of D, *a* > 2 x D is satisfied.

2. The film deposition method for the optical disk according to claim 1, wherein when a distance between the target and the optical disk substrate is h, *a* < D + h is satisfied.

3. The film deposition method for the optical disk according to claim 1 or 2, wherein when a distance between the target and the optical disk substrate is h, h > 30 mm is satisfied.

4. The film deposition method for the optical disk according to claim 1, wherein in the step (c), the predetermined film is laminated as a fine layered structure in order to form a recording layer of the optical disk.

5. The film deposition method for the optical disk according to claim 4, wherein each layer laminated as the fine layered structure has a thickness equal to or less than a width of a magnetic domain wall or in an order of unit atom.

6. The film deposition method for the optical disk according to claim 4, wherein in the step (c), a film structure of the recording film is formed into the fine layered structure by alternately repeating conduction and non-conduction to the target by using a direct-current power supply.

7. The film deposition method for the optical disk according to claim 4, wherein in the step (c) , the film is formed while the optical disk substrate is revolved or rotated on its axis, and a film forming area on the optical disk substrate is entirely or partially shielded in synchronization with a rotation period of the revolution or the rotation by using a shielding member placed between the optical disk substrate and the target.

8. The film deposition method for the optical disk according to claim 7, wherein the shielding member is a shielding plate made of a metal, and direct-current negative voltage is applied to a cathode electrode connecting the target.

9. The film deposition method for the optical disk according to claim 8, wherein the shielding plate shields 50 % or more of the film forming area on the optical disk substrate.

10. The film deposition method for the optical disk according to claim 7, wherein the revolving or rotating optical disk substrate is 100 rpm or more in number of revolution.

11. The film deposition method for the optical disk according to claim 4, wherein a plurality of vacuum chambers are provided, a step (d) of carrying the optical disk between the vacuum chambers is provided, and
a magnetic layer laminated in the fine layered structure is formed in the step (c) while the optical disk is passed through some or all of the vacuum chambers.

12. The film deposition method for the optical disk according to claim 11, wherein targets placed in each of the plurality of vacuum chambers have same material or composition.

13. The film deposition method for the optical disk according to claim 11, wherein target placed in each of the plurality of vacuum chambers is a target material obtained by combining different compositions.
